(19) Europäisches Patentamt
European Patent Office
Office européen des brevets

(11) **EP 2 948 503 B1**

(12) **EUROPÄISCHE PATENTSCHRIFT**

(45) Veröffentlichungstag und Bekanntmachung des Hinweises auf die Patenterteilung:
**04.04.2018 Patentblatt 2018/14**

(51) Int Cl.:
***C08K 3/00*** *(2018.01)*     ***C09K 21/02*** *(2006.01)*
***C01F 7/06*** *(2006.01)*

(21) Anmeldenummer: **14738718.7**

(22) Anmeldetag: **16.01.2014**

(86) Internationale Anmeldenummer:
**PCT/DE2014/000014**

(87) Internationale Veröffentlichungsnummer:
**WO 2014/114284 (31.07.2014 Gazette 2014/31)**

(54) **NEUARTIGES ANORGANISCHES, HALOGENFREIES FLAMMSCHUTZMITTEL AUF BASIS VON CHEMISCH MODIFIZIERTEM REKARBONISIERTEM ROTSCHLAMM**

NOVEL INORGANIC, HALOGEN-FREE FLAMEPROOFING AGENT ON THE BASIS OF CHEMICALLY MODIFIED RECARBONIZED RED MUD

NOUVEL AGENT IGNIFUGE INORGANIQUE SANS HALOGÈNE À BASE DE BOUE ROUGE CHIMIQUEMENT MODIFIÉE RECARBONISÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.01.2013 DE 102013001520**

(43) Veröffentlichungstag der Anmeldung:
**02.12.2015 Patentblatt 2015/49**

(73) Patentinhaber: **Fluorchemie Frankfurt GmbH 65296 Frankfurt (DE)**

(72) Erfinder: **ROCKTÄSCHEL, Christian 50126 Bergheim (DE)**

(74) Vertreter: **Schäfer, Matthias W. Patentanwalt Schwanseestrasse 43 81549 München (DE)**

(56) Entgegenhaltungen:
**WO-A1-2012/126487     CN-A- 101 624 457**

- **SUNIL K. SHARMA ET AL: FIRE TECHNOLOGY, Bd. 38, Nr. 1, 1. Januar 2002 (2002-01-01) , Seiten 57-70, XP055012990, ISSN: 0015-2684, DOI: 10.1023/A:1013428831840**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 948 503 B1

**Beschreibung**

Gebiet der Erfindung

Die vorliegende Erfindung betrifft ein anorganisches, halogenfreies Flammschutzmittel aus modifiziertem, karbonisiertem Rotschlamm (MKRS-HT), das im Hochtemperaturbereich als Flammhemmer eingesetzt werden kann, sowie ein anorganisches, halogenfreies Flammschutzmittel aus modifiziertem, karbonisiertem und rehydratisiertem Rotschlamm (MR2S-NT), das sowohl im Niedrigtemperaturbereich als auch im Hochtemperaturbereich als Flammhemmer eingesetzt werden kann, Verfahren zu deren Herstellung sowie deren Verwendung als Flammhemmer. Ferner betrifft die vorliegende Erfindung ein brandgeschütztes Stoffsystem sowie Verfahren zu dessen Herstellung. Ferner kann das erfindungsgemäße Flammschutzmittel in weiteren Anwendungen eingesetzt werden, wie z.B. zur Wärmedämmung und zur Wärmespeicherung, zur Schalldämmung und zur Abschirmung von elektromagnetischen Wellen, zum Ersatz von Schwerspat und zum Ersatz von Antimontrioxid.

Hintergrund der Erfindung

FLAMMHEMMUNG

Flammschutzmittel sind Brandhemmer, die die Ausbreitung von Bränden einschränken, verlangsamen oder verhindern sollen.

Flammschutzmittel finden überall dort Verwendung, wo sich potentielle Zündquellen befinden, bzw. dort wo die Verwendung brennbarer Materialen ein Sicherheitsrisiko darstellt. Steigende Anforderungen an die Sicherheit und die zunehmende Verwendung hochwertiger Kunststoffe anstelle von Metallen und Metalllegierungen, z. B. im Bauwesen, Flugzeug und Automobilbau sowie bei Innenausstattungen, haben zu einem zunehmenden Bedarf an Flammschutzmitteln geführt.

Die Wirkungsweise von Flammschutzmitteln beruht auf unterschiedlichen Effekten:

- Unterbrechung der Radikalkettenreaktion der bei der Pyrolyse des Materials entstehenden Gase;
- Bildung einer Schutzschicht aus verkohltem Material (Intumeszenz), um den Zutritt von Sauerstoff und Wärme zu verhindern;
- Kühlung des Verbrennungsprozesses durch Auslösung einer endothermen Zersetzung, bzw. Verdampfung von gebundenem Wasser;
- Verdünnung der brennbaren Gase durch inerte, gasförmige Substanzen (wie z. B. $CO_2$, das durch endotherme Zersetzung von Karbonaten entsteht.);
- Verflüssigung, d. h. Bildung einer Schmelze, die aus der Brandzone fließt und gleichzeitig die Oberfläche verringert.

Die meisten Flammschutzmittel lösen einen oder mehrere der erwähnten chemischphysikalischen Effekte aus:

Daher unterscheidet man die folgenden 4 Typen von Flammschutzmitteln:

- additive Flammschutzmittel - diese werden in die brennbaren Stoffe eingearbeitet;
- reaktive Flammschutzmittel - Substanzen, die durch Einpolymerisation in Kunststoffe selbst Bestandteil des Materials sind;
- inhärente Flammschutzmittel - das Material an sich ist flammwidrig;
- Coating - das Flammschutzmittel wird von außen als Beschichtung auf den brennbaren Stoff aufgetragen.

Dabei gibt es bei reaktiven Flammschutzmitteln drei verschiedene Hauptansätze, um einen gewissen Flammschutz in Polymersystemen zu erreichen:

- Intumeszierende FR-Systeme (englisch: flame retardant): Beispielsweise MelaminDerivate mit Polymer;
- Halogenfreie FR-Systeme: Insbesondere Aluminiumhydroxid (ATH), Magnesiumhydroxid (MDH), Ammoniumpolyphosphat (APP); und/oder
- Halogenenthaltende FR-Systeme: Beispielsweise Polyvinylchlorid (PVC) mit Antimontrioxid ($Sb_2O_3$) und/oder halogenorganische FR mit Antimontrioxid ($Sb_2O_3$) und Polymer.

Wichtige reaktive und inhärente, aber auch additive Flammschutzmittel sind inzwischen aus toxikologischen Gründen, insbesondere wegen der Bildung von toxischen bzw. umweltschädlichen Gasen beim Zersetzungsprozess, in die Kritik geraten und unterliegen derzeit einer strengen Risikobewertung. Dies trifft insbesondere auf halogenhaltige Flammschutzmittel zu, so dass ein großer Bedarf an so genannten Zero-Halogen Flame Retardants (OHFR)-Füllstoffen besteht und insbesondere anorganische Flammschutzmittel zunehmend an Bedeutung gewonnen haben und weiter gewinnen.

Aluminiumhydroxid (ATH) ist mengenmäßig der wichtigste anorganische Flammschutz. Anfangs wurde ATH in Polyolefinsystemen, insbesondere für so genannte Wire & Cable (W&C)-Anwendungen, eingesetzt.

Seit den 70er Jahren des letzten Jahrhunderts wurden vermehrt Alternativen hierzu getestet, wie z.B. Magnesiumhydroxid (MDH), das eine höhere Zersetzungstemperatur aufweist und auch in Systemen wie Polypropylen und Polyamiden als OHFR-Füllstoff Verwendung fand und findet. Nachteilig an MDH ist zum einen dessen vergleichsweise hoher Preis und zum anderen treten Probleme bei Verarbeitungstemperaturen über 300° C auf, da sich hier die im Markt befindlichen Produkte bereits unter Wasserabspaltung zersetzen.

Parallel zu ATH kamen Ammoniumpolyphosphat (APP) und seine Derivate auf, die aber u.a. den Nachteil der Empfindlichkeit gegen Feuchte (Wasserlagerungstests bei elektrischen Bauteilen) aufweisen und schon bei einer Temperatur von 170°C Ammoniak freisetzten.

Bei den technischen Thermoplasten, wie beispielsweise Polyamiden und Polyestern, wurden neben Magnesiumhydroxid Melaminderivate wie Melaminisocyanurat, Melamincyanurat und Melaminpolyphosphat eingesetzt.

Darüber hinaus treten bei Beladungsgraden von bis zu 65 Gew. % des jeweiligen OHFR-Füllstoffs im flammgeschützten Polymercompound, was beispielsweise zur Erreichung einer gewünschten Brandklasse (z.B. UL 94 Vertikal V-0) erforderlich sein kann, technische Probleme hinsichtlich Verarbeitung (Extrusionsverhalten) sowie Eigenschaftsprofil-Probleme (Abfall der mechanischen und elektrischen Werte im Vergleich zum ungefüllten Polymer) auf. Diese Schwierigkeiten steigen bei noch höheren Beladungsgraden - quasi exponentiell- und stellen höchste Anforderungen an Compoundierequipment und Operatoren. Diese Aussage gilt in noch verstärktem Maße für die so genannte Construction Protection Directive ("CPD") (vgl. prEN 50399), welche zur Eingruppierung der FR-Compounds in die so genannte "Euro Classes" nochmals stark verschärfte Anwendungen neuer FR-Tests bedingt. Bei so hohen Füllgraden sind flammgeschützte Polymercompounds technisch praktisch nicht mehr darstellbar und nicht mehr zu verarbeiten. Im Zuge der Entwicklung von CPD-konformen OHFR Polymercompounds wurde weiterhin die Verwendung von so genannten Nanoclays als Synergisten beschrieben und beispielsweise unter den Marken Cloisite ® und Nanofil ® technisch im Markt eingeführt.

Da die daraus resultierenden Polymercompoundsysteme immer komplexer und kostenintensiver wurden, schlugen die Erfinder der vorliegenden Erfindung einen völlig anderen Weg ein.

Es ist bekannt, dass Rotschlamm, der beim Bayer-Verfahren zur Gewinnung von Aluminiumhydroxid (ATH) aus Bauxit als Abfallprodukt anfällt, profunde OHFR-Eigenschaften aufweisen. Unter Rotschlamm (RS) wird im Folgenden der beim Bayer-Verfahren entstandene Rückstand verstanden, der bei der Gewinnung von ATH aus Bauxit anfällt.

Rotschlamm (RS), der in gewisser Weise als Bauxit minus ATH dargestellt werden kann, ist eine äußerst heterogene Substanz hinsichtlich seiner chemischen und mineralogischen Zusammensetzung, seiner endothermen Eigenschaften, seines pH- Wertes, etc. Die Ursache für die Heterogenität liegt einmal in der unterschiedlichen Zusammensetzung der eingesetzten Bauxite, vor allem aber darin, ob das Bayer-Verfahren mit Autoklavenaufschluss oder mit Rohraufschluss arbeitet. Beim Autoklavenverfahren wird der Aufschluss mit 30 bis 35 prozentiger Natronlauge bei Temperaturen von 170 - 180 °C durchgeführt, so dass sich ein Druck von 6 bis 8 bar einstellt. Das Rohraufschlussverfahren wurde entwickelt, um die Reaktionszeit von 6 bis 8 Stunden durch Temperaturerhöhung auf 270 °C auf weniger als 1 Stunde zu verkürzen. Bei dieser Temperatur stellt sich allerdings ein Wasserdampfdruck von 60 bar am Ende des Reaktors ein. Die höheren Temperaturen des Rohraufschlusses beeinflussen auch die Zusammensetzung des Rotschlamms. Beispielsweise wird im System Eisenhydroxid/Oxidhydrat im Rohraufschlussverfahren das Gleichgewicht fast vollständig zu Hämatit ($Fe_2O_3$) hin verschoben. Aufgrund der Heterogenität des Rotschlamms (RS) sind seine wirtschaftlichen Verwendungsmöglichkeiten eingeschränkt, so dass er überwiegend als Abfall auf Deponien entsorgt werden muss.

In der WO 2012/126487 A1 wurde ein OHFR-System, basierend auf modifiziertem rehydratisiertem Rotschlamm (MR2S) beschrieben, das sich als ein kostengünstiges OHFR-System für technische Anwendungen im Wire & Cable-Bereich oder für bautechnische und kunststofftechnische Anwendungen eignet. Mit Hilfe des in der WO 2012/126487 A1 offenbarten modifizierten rehydratisierten Rotschlamms kann eine flammhemmende Wirkung im Temperaturbereich von ca. 200°C - 350°C erreicht werden. Die flammhemmende Wirkung kommt dadurch zustande, dass sich die bei der Rehydratisierung des Rotschlamms entstandenen Hydroxide und Oxidhydrate des Aluminiums und Eisens - wie z. B. Gibbsit und Boehmit oder Goethit - in Oxide und Wasser zersetzen. Anwendung finden solche Produkte z. B. in Polymersystemen wie PVC oder EVA (PE). Bisher im Markt eingesetzte Produkte wie ATH oder APP reagieren zwischen 180° und 220° C und gelten als Niedrigtemperatur-Produkte. Zwischen 220° und 340° C werden Produkte wie MDH und Brucit eingesetzt, die als Hochtemperatur-Produkte gelten. Die aus RS durch Rehydratisierung hergestellten Flammhemmer (MR2S) reagieren zwischen ca. 220° C und 350° C und decken damit nach gegenwärtig üblicher Definition sowohl den Niedrigtemperatur- wie den Hochtemperaturbereich ab.

Im Rahmen der vorliegenden Erfindung wird aber der Temperaturbereich zwischen 220° C und 350° C als Niedrigtemperaturbereich eingestuft, MR2S erhält den Zusatz NT (Niedrigtemperatur) und heißt somit MR2S-NT.

Die CN 101 624 457 A offenbart ein PE-Polymer, das als Flammschutzmittel eine Kombination aus Rotschlamm und Synergisten enthält. Hierbei kommt ein herkömmlicher Rotschlamm, wie er z.B. nach einem Bayer-Verfahren erhalten wird, zum Einsatz, der SiO2, CaO, Al2O3 und Fe2O3 als Hauptbestandteile enthält, zerkleinert wird und bei 80-100°C getrocknet wird.

Sunil K. Sharma und A.A. Ansari beschreiben in Fire Technology, 38, 57-70, 2002, Plastikmaterialien, die herkömmlichen Oxiden aus bestehenden Rotschlamm enthalten, und untersuchen das Verhalten dieser Plastikmaterialien gegenüber Feuer.

Allerdings besteht zunehmend der Bedarf nach Substanzen, die ihre flammhemmende Wirkung in höheren Temperaturbereichen entfalten, so genannten Hochtemperatur (HT)-Flammhemmer. Im Rahmen der vorliegenden Erfindung wird als Hochtemperaturbereich der Temperaturbereich zwischen 350° C und 500° C bezeichnet.

Zusammenfassung der Erfindung

Der vorliegenden Erfindung lag daher die Aufgabe zugrunde, ein kostengünstiges halogenfreies Flammschutzmittel bereitzustellen, das eine flammhemmende Wirkung im Hochtemperaturbereich, in besonders vorteilhafter Weise sowohl im Hochtemperaturbereich als auch im Niedrigtemperaturbereich, aufweist.

Überraschenderweise wurde herausgefunden, dass sich aus Rotschlamm durch eine andere Modifizierung als der in der WO 2012/126487 A1 beschriebenen Rehydratisierung, nämlich durch eine Karbonisierung, ein OHFR-System aufbauen lässt, das für den Hochtemperaturbereich geeignet ist.

Durch Reduktion von Rotschlamm im sauren Milieu können aus den im Rotschlamm vorliegenden Fe(III)-Verbindungen Fe(II)-Salzlösungen erhalten werden, aus denen durch Zugabe von beispielsweise $NaHCO_3$, Na2CO3 oder $CaCO_3$ Eisen(II)-carbonat (Siderit) ausgefällt werden kann. Ohne an eine Theorie gebunden sein zu wollen, gehen die Erfinder davon aus, dass durch eine Karbonisierung von Rotschlamm unter Bildung von Eisen(II)-carbonat ein Hochtemperatur(HT)-Flammschutzmittel erhalten werden kann, der seine endotherme Wirkung durch Spaltung in Oxid und $CO_2$ bis zu Temperaturen von mehr als 500°C entfaltet. Neben der endothermen Reaktion wirkt das freigesetzte CO2 als Flammschutzmittel.

Die vorliegende Erfindung betrifft daher ein anorganisches, halogenfreies Flammschutzmittel aus modifiziertem, karbonisiertem Rotschlamm (MKRS-HT) mit einer mineralischen Zusammensetzung von

- 10 bis 50 Gewichtsprozent (Gew.%) Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen,

wobei das Gewichtsverhältnis von Fe(II)carbonat zu den Oxiden des Eisens mindestens 1 ist.

Da dieses Produkt durch Karbonisierung entsteht, erhält es den Namen MKRS (modifizierter karbonisierter Rotschlamm). Da es sich um einen Hochtemperatur-Flammhemmer handelt, erhält dieser den Zusatz HT (Hochtemperatur), seine Bezeichnung ist also MKRS-HT.

Es wurde darüber hinaus herausgefunden, dass aus Rotschlamm durch Rehydratisierung sowie Karbonisierung ein besonders vorteilhaftes anorganisches, halogenfreies Flammschutzmittel erhalten werden kann, das sowohl für den Hochtemperaturbereich als auch für den Niedrigtemperaturbereich geeignet ist und somit einen universell einsetzbaren Flammhemmer für einen sehr breiten Temperaturbereich darstellt.

Der modifizierte karbonsierte Rotschlamm kann insbesondere ein modifizierter, karbonisierter und rehydratisierter Rotschlamm sein, bei dem das Gewichtsverhältnis von Fe(II)carbonat und das Gewichtsverhältnis der Summe von Eisenhydroxid und Eisenoxidhydrat zu den Oxiden des Eisens mindestens 1 beträgt.

In diesem Fall liegen vorzugsweise neben den Hydroxiden/Oxidhydraten des Eisens und Fe(II)-Carbonat auch Hydroxide/Oxidhydrate des Aluminiums vor, die eine weitere Verstärkung der flammhemmenden Wirkung aufgrund ihrer endothermen Eigenschaften erzeugen können. Zusätzlich können noch Phasenumwandlungen in anderen Bestandteilen des Rotschlamms endotherm zur Wirkung kommen. Insgesamt können in mit solchen erfindungsgemäßen OHFR-Produkten ausgerüstete Polymercompounds endotherme Reaktionen über einen Temperaturbereich von 180°C bis mehr als 500°C ablaufen. Zusätzlich wird noch flammhemmendes CO2 freigesetzt.

Die vorliegende Erfindung betrifft ferner ein Verfahren zur Herstellung des anorganischen, halogenfreien Flammschutzmittels aus modifiziertem, karbonisiertem Rotschlamm (MKRS-HT), umfassend die Schritte:

a) Bereitstellen von Rotschlamm,

b) Reduzieren der in dem Rotschlamm enthaltenen Eisen(III)-Verbindungen in saurer Lösung zu Eisen(II)-Verbindungen,

c) Zugeben einer Carbonatverbindung zu der in Schritt b) erhaltenen Eisen(II)-Verbindungen enthaltenden Lösung, wobei Eisen(II)carbonat (Siderit) gebildet wird.

Die vorliegende Erfindung betrifft ferner ein weiteres Verfahren zur Herstellung des anorganischen, halogenfreien Flammschutzmittels aus modifiziertem Rotschlamm, umfassend die Schritte:

a) Bereitstellen von Rotschlamm (RS);
b) Separate Herstellung von Eisen(II)carbonat aus zur Verfügung stehenden Ausgangssubstanzen;
c) Vermischen von RS und Eisen(II)carbonat
d) Erhalten von modifiziertem karbonisiertem Rotschlamm (MKRS-hat).

Auf diesem Weg kann das Eisen(II)carbonat leicht Modifikationen durch physikalische und/oder chemische Methoden unterzogen werden, um speziell anwendungstechnische Eigenschaften zu erreichen.

Die vorliegende Erfindung betrifft ferner ein brandgeschütztes Stoffsystem, umfassend ein brennbares Material und ein erfindungsgemäßes Flammschutzmittel.

Die vorliegende Erfindung betrifft ferner die Verwendung eines erfindungsgemäßen Flammschutzmittels als Flammhemmer für brennbare Materialien, insbesondere brennbare Baustoffe, Gummi, Spanplattenmaterial, Kunststoffe, insbesondere Kabelummantelungen, Kabelisolationsmasse oder Kabelfüll-Compounds.

Die vorliegende Erfindung betrifft ferner ein Verfahren zur Herstellung eines brandgeschützten Stoffsystems, umfassend die Schritte:

a) Bereitstellen eines brennbaren Materials,
b) Beschichten oder Vermengen des brennbaren Materials mit einem erfindungsgemäßen Flammschutzmittel, und dadurch
c) Erhalten des brandgeschützten Stoffsystems.

Weiterhin wurde herausgefunden, dass chemisch modifizierter, rehydratisierter und karbonisierter Rotschlamm sowie Mischungen daraus eine Dichte von ca. 3,8 - 3,9 $10^3$ kg / $m^3$ aufweisen und damit BaSO4 (Schwerspat), der eine Dichte von 4,43 $10^3$ kg / $m^3$ hat, nahe kommen. BaSO4 wird wegen seines spezifischen Gewichts unter anderem auch als schwerer Füllstoff in Kunststoffen eingesetzt. Wird nun an Stelle von Schwerspat Rotschlamm bzw. seine chemisch modifizierten Varianten MR2S-NT bzw. MKRS-HT oder Mischungen davon eingesetzt, erhält so compoundierter Kunststoff gleichzeitig eine flammhemmende Ausrüstung, es liegt also ein Doppeleffekt vor.

Weiterhin zeigen chemisch modifizierter, rehydratisierter und karbonisierter Rotschlamm , sowie Mischungen daraus in Verbindung mit einer Trägermatrix eine schalldämmende Wirkung. Sind also Kunststoffe oder z. B. Baustoffe mit diesen Produkten ausgerüstet, tritt neben der flammhemmenden auch eine schalldämmende Wirkung auf. Diese Doppelwirkung ist insbesondere bei Einsatz im Fahrzeugbau und Baubereich interessant. Baustoffe können auch mineralische Produkte wie Estrich, Beton, Gipskartonplatten, etc. sein, die dann eine entsprechende Schalldämmung aufweisen.

Weiterhin betrifft die vorliegende Erfindung die vorteilhafte Verwendung des erfindungsgemäßen Flammschutzmittels und/oder Mischungen davon, insbesondere Mischungen mit Rotschlamm, als Füllstoff, Substitut bzw. Ersatzmittel, Synergist, thermischen Stabilisator, Wärmespeicher, Wärmedämmer, Wärmeisolator, Schalldämmer, Schallschutz und/oder als Material zur Abschwächung bzw. Abschirmung von elektromagnetischer Strahlung.

Vorteilhafte Weiterentwicklungen der vorliegenden Erfindung sind jeweils Gegenstand von Unteransprüchen und Ausführungsformen.

Erfindungsgemäßen Ausführungsformen der vorliegenden Erfindung können eines oder mehrere der im Folgenden genannten Merkmale aufweisen.

Manche oder alle erfindungsgemäßen Ausführungsformen der vorliegenden Erfindung können einen, mehrere oder alle der im Folgenden genannten Vorteile aufweisen.

Ausführliche Beschreibung der Erfindung

Die Begriffe "Flammschutzmittel", "flammhemmendes Mittel", "Flammhemmer" und "OHFR-Agenzien" oder auch die Abkürzung "FR" (englisch: flame retardant) sind im Rahmen der vorliegenden Erfindung als Synonyme zu verstehen. Hierunter werden im Sinne der vorliegenden Erfindung insbesondere nicht toxische, halogenfreie, anorganische Flammschutzmittel verstanden, insbesondere modifizierter, karbonisierter Rotschlamm (MKRS-HT) bzw. modifizierter, karbonisierter und rehydratisierter Rotschlamm

Unter "Niedrigtemperaturbereich" wird im Sinne der vorliegenden Erfindung der Temperaturbereich zwischen 220° C und 350° C verstanden.

Unter "Hochtemperaturbereich" wird im Sinne der vorliegenden Erfindung der Temperaturbereich zwischen 350° C und 500° C verstanden.

Unter dem Begriff "brandgeschütztes Stoffsystem" wird ein Gegenstand verstanden, bei dem ein brennbares Material mit einem flammhemmenden Mittel in Verbindung gebracht wird, so dass das Entzünden des in dem Gegenstand vorhandenen brennbaren Materials durch Feuer oder Hitze verhindert oder verlangsamt wird. Insbesondere ist das flammhemmende Mittel mit dem brennbaren Material fest verbunden, beispielsweise durch Vermengen oder Beschichten.

Unter "brennbaren Materialien" oder "entflammbaren Materialien" werden jegliche Materialien verstanden, die brennbar oder entflammbar sind, insbesondere Polymere und nicht flüchtige Kohlenwasserstoffe. Beispiele sind Acryldispersionen, Acrylharze, Elastomere, Epoxidharze, Latexdispersionen, Melaminharze, Polyamid (PA), Polyethylen (PE), PE-Copolymere, thermoplastische PE-Copolymere, vernetzte PE-Copolymere, Phenolharze, Polyesterharze (UP), Polyurethan, Polypropylen (PP), Polyvinylchlorid (PVC), PVC-Plastisole, thermoplastische Elastomere wie z. B. TPE, TPA, TPU, etc., Vinylesterharze und Bitumen. Brennbar und entflammbar sind hier als Synonyme zu verstehen.

Unter Rotschlamm (RS) wird der beim Bayer-Verfahren entstehende Rückstand verstanden, der bei der Gewinnung von ATH aus Bauxit anfällt. Weitere Informationen zu Rotschlamm finden sich in der WO 2012/126487 A1, deren Offenbarung hiermit vollumfänglich als integraler Bestandteil dieser Anmeldung aufgenommen wird. Unter modifiziertem, karbonisiertem Rotschlamm (MKRS-HT) wird ein Produkt verstanden, dass aus Rotschlamm (RS) durch Karbonisierung und ggf. Trocknen, Mahlen, Zumischen anderer Substanzen, Beschichtung der Oberfläche, etc. hergestellt wird. Unter modifiziertem, karbonisiertem und rehydratisiertem Rotschlamm wird ein Produkt verstanden, dass aus Rotschlamm (RS) durch Karbonisierung sowie Rehydratisierung und ggf. Trocknen, Mahlen, Zumischen anderer Substanzen, Beschichtung der Oberfläche, etc. hergestellt wird.

Die vorliegende Erfindung betrifft ein anorganisches, halogenfreies Flammschutzmittel aus modifiziertem, karbonisiertem Rotschlamm (MKRS-HT) mit einer mineralischen Zusammensetzung von

- 10 bis 50 Gewichtsprozent (Gew.%) Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen,

wobei das Gewichtsverhältnis von Fe(II)carbonat zu den Oxiden des Eisens mindestens 1 ist.

In dem anorganischen, halogenfreien Flammschutzmittel aus modifiziertem, karbonisiertem Rotschlamm (MKRS-HT) beträgt das Gewichtsverhältnis von Fe(II)carbonat zu den Oxiden des Eisens vorzugsweise mindestens 1, stärker bevorzugt mindestens 2, stärker bevorzugt mindestens 3, stärker bevorzugt mindestens 4, stärker bevorzugt mindestens 5, stärker bevorzugt mindestens 7, stärker bevorzugt mindestens 9, stärker bevorzugt mindestens 19. Zur Verdeutlichung, wenn beispielsweise das Gewichtsverhältnis von Fe(II)carbonat zu den Oxiden des Eisens 19 beträgt und unter der Annahme, dass sämtliche Eisenverbindungen entweder als Fe(II)carbonat oder als Oxide des Eisens vorliegen, liegen 95 Gewichtsprozent der Eisenverbindungen als Fe(II)carbonat und 5 Gewichtsprozent der Eisenverbindungen als Oxide des Eisens vor.

Der modifizierte karbonsierte Rotschlamm kann insbesondere ein modifizierter, karbonisierter und rehydratisierter Rotschlamm (MR2S-NT) sein, bei dem das Gewichtsverhältnis von Fe(II)carbonat und das Gewichtsverhältnis der Summe von Eisenhydroxid und Eisenoxidhydrat zu den Oxiden des Eisens mindestens 1 beträgt.

In dem anorganischen, halogenfreien Flammschutzmittel aus modifiziertem, karbonisiertem und rehydratisiertem Rotschlamm beträgt das Gewichtsverhältnis von Fe(II)carbonat und Eisenhydroxid/Oxidhydraten zu den Oxiden des Eisens vorzugsweise mindestens 1, stärker bevorzugt mindestens 1,5, stärker bevorzugt mindestens 2, stärker bevorzugt mindestens 3, stärker bevorzugt mindestens 4, stärker bevorzugt mindestens 5, stärker bevorzugt mindestens 7, stärker bevorzugt mindestens 9, stärker bevorzugt mindestens 19.

Zur Verdeutlichung, wenn beispielsweise das Gewichtsverhältnis von Fe(II)carbonat zu den Oxiden des Eisens 2 beträgt und das Gewichtsverhältnis der Summe von Eisenhydroxid und Eisenoxidhydrat zu den Oxiden des Eisens ebenfalls 2 beträgt und unter der Annahme, dass sämtliche Eisenverbindungen entweder als Fe(II)carbonat, Eisenhydroxid, Eisenoxidhydrat oder als Oxide des Eisens vorliegen, liegen 40 Gewichtsprozent der Eisenverbindungen als Fe(II)carbonat, 40 Gewichtsprozent der Eisenverbindungen als Eisenhydroxid bzw. Eisenoxidhydrat und 20 Gewichtsprozent der Eisenverbindungen als Oxide des Eisens vor.

In dem anorganischen, halogenfreien Flammschutzmittel aus modifiziertem, karbonisiertem und rehydratisiertem Rotschlamm liegen vorzugsweise neben den Hydroxiden/Oxidhydraten des Eisens und Fe(II)-Carbonat, auch Hydroxide/Oxidhydrate des Aluminiums vor, die eine weitere Verstärkung der flammhemmenden Wirkung aufgrund ihrer endothermen Eigenschaften erzeugen können. Hierbei beträgt das Gewichtsverhältnis der Summe von Aluminiumhydroxid und Aluminiumoxidhydrat zu Aluminiumoxid vorzugsweise mindestens 1, stärker bevorzugt mindestens 1,5, stärker bevorzugt mindestens 2, stärker bevorzugt mindestens 3, stärker bevorzugt mindestens 4, stärker bevorzugt mindestens 5, stärker bevorzugt mindestens 7, stärker bevorzugt mindestens 9, stärker bevorzugt mindestens 19.

Sofern nicht explizit etwas anderes vermerkt ist, gelten die folgenden Ausführungen sowohl für das anorganische, halogenfreie Flammschutzmittel aus modifiziertem, karbonisierten Rotschlamm (MKRS-HT) als auch für das erfindungsgemäße anorganische, halogenfreie Flammschutzmittel aus modifiziertem, karbonisiertem und rehydratisiertem Rotschlamm (MR2S-NT), die beide zusammengenommen im folgenden auch vereinfacht als "modifizierter Rotschlamm" oder "(erfindungsgemäßes) Flammschutzmittel" bezeichnet werden.

Die mineralische Zusammensetzung des modifizierten Rotschlamms umfasst:

- 10 bis 50 Gewichtsprozent Eisenverbindungen,
- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen.

Dabei kann die mineralische Zusammensetzung des modifizierten Rotschlamms 10 bis 45, 30 bis 50, oder 20 bis 40 Gewichtsprozent Eisenverbindungen umfassen.

Dabei kann die mineralische Zusammensetzung 12 bis 30, 20 bis 35, oder 15 bis25 Gewichtsprozent Aluminiumverbindungen umfassen.

Dabei kann die mineralische Zusammensetzung 5 bis 15, 8 bis 17, oder 7 bis 16 Gewichtsprozent Siliziumverbindungen, insbesondere $SiO_2$, umfassen.

Dabei kann die mineralische Zusammensetzung 4 bis 10, 2 bis 8, oder 3 bis 9 Gewichtsprozent Titandioxid ($TiO_2$ umfassen.

Dabei kann die mineralische Zusammensetzung 1 bis 6, 0,5 bis 2,5, 0,75 bis 4, oder 0,6 bis 1,5 Gewichtsprozent Calciumverbindungen, insbesondere CaO, umfassen.

Dabei kann jeder der oben angegebenen Bereiche kombiniert werden.

Unter "unvermeidbare Verunreinigungen" werden Bestandteile verstanden, die als Verunreinigung in den Ausgangsmaterialen, beispielsweise in dem einem Bayer-Verfahren unterworfenen Bauxit, oder Verunreinigungen, die herstellungsbedingt entstehen oder Eingang in das Produkt finden. Insbesondere aufgrund der Heterogenität des Rotschlamms, wie eingangs erwähnt, sind solche Verunreinigungen nicht vermeidbar. Sie tragen aber nicht entscheidend zur flammhemmenden Wirkung des modifizierten Rotschlamms bei.

In einer Weiterbildung der Erfindung beträgt der Anteil an wasserlöslichem Natriumverbindungen, ausgedrückt als Gewichtsprozent $Na_2O$, in dem modifizierten Rotschlamm nicht mehr als 0,03, vorzugsweise 0,003 bis 0,03 Gewichtsprozent.

In noch einer Weiterbildung der Erfindung beträgt die mittlere Teilchengröße (d50) in dem modifizierten Rotschlamm nicht mehr als 50 $\mu$m, vorzugsweise 0,5 bis 10 $\mu$m oder 1 bis 5 $\mu$m (mikroskaliger modifizierte Rotschlamm) bzw. 100 bis 900 nm oder 200 bis 750 nm (nanoskaliger modifizierte Rotschlamm).

In noch einer Weiterbildung der Erfindung beträgt die Restfeuchte des modifizierten Rotschlamms nicht mehr als 0,4 Gewichtsprozent, vorzugsweise nicht mehr als 0,3 Gewichtsprozent, vorzugsweise nicht mehr als 0,2 Gewichtsprozent.

Die chemische Zusammensetzung von Rotschlamm ist in Tabelle 1, die chemische Zusammensetzung von MKRS-HT in Tabelle 2 und die chemische Zusammensetzung von modifiziertem, karbonisierten und rehydratisierten Rotschlamm in Tabelle 3 (MR2S-NT) dargestellt.

**Tabelle 1**

| Rotschlamm (Gewichtsprozent) | | |
|---|---|---|
| | Typisch | Bandbreite |
| Eisenverbindungen | 40 | 10 - 50 |
| Aluminiumverbindungen | 25 | 12 - 35 |
| Siliziumverbindungen (v.a. $SiO_2$) | 15 | 5 - 17 |
| Titandioxid | 7 | 2 - 10 |
| Calciumverbindungen | 1 | 0,5 - 6 |

(fortgesetzt)

| Rotschlamm (Gewichtsprozent) | | |
|---|---|---|
| | Typisch | Bandbreite |
| Natriumverbindungen | 9 | 3 - 10 |
| Sonstige | 3 | 0 - 3 |

**Tabelle 2**

| MKRS - HT | |
|---|---|
| Eisenverbindungen | Gewichtsverhältnis von Fe(II)carbonat zu den Oxiden des Eisens mindestens 1 |
| Aluminiumverbindungen | unverändert als Al-Salze oder $Al_2O_3$ |
| $Na_2O$ lösl. | vorzugsweise kleiner gleich 0,03 Gewichts% |
| andere Bestandteile des RS | unverändert |
| mittlere Teilchengröße (d 50) | vorzugsweise kleiner gleich 50 $\mu$m, vorzugsweise 0,5 - 10 $\mu$m |
| Restfeuchte | vorzugsweise kleiner gleich 0,4 Gewichts% |

**Tabelle 3**

| MR2S-NT | |
|---|---|
| Eisenverbindungen | Gewichtsverhältnis von Fe(II)carbonat und der Summe von Eisenhydroxid und Eisenoxidhydrat zu den Oxiden des Eisens mindestens 1 |
| Aluminiumverbindungen | Gewichtsverhältnis der Summe von Aluminiumhydroxid und - oxidhydrat zu Aluminiumoxid vorzugsweise mindestens 1 |
| $Na_2O$ lösl. | vorzugsweise kleiner gleich 0,03 Gewichts% |
| andere Bestandteile des RS | unverändert |
| mittlere Teilchengröße (d 50) | vorzugsweise kleiner gleich 50 $\mu$m, vorzugsweise 0,5 - 10 $\mu$m |
| Restfeuchte | vorzugsweise kleiner gleich 0,4 Gewichts% |

Es ist weiterhin bevorzugt, wenn die Oberfläche des modifizierten Rotschlamms mit mindestens einer Substanz versehen ist, welche die Verträglichkeit der Teilchen des modifizierten Rotschlamms mit einer Polymermatrix verbessert. Hierdurch kann die Einarbeitung des modifizierten Rotschlamms in das zu schützende brennbare Material, das in der Regel eine Polymermatrix aufweist, erleichtert werden und die Bindung der Komponenten verbessert werden. Ebenfalls kann hierdurch das Eigenschaftsprofil des Polymercompounds gezielt gesteuert werden.

Als vorteilhaft hat sich hierbei erwiesen, wenn die Substanz ein Oberflächenmodifizierungsmittel ist, ausgewählt aus der Gruppe, bestehend aus Organosilanen, Organotitanaten, Organo-Zirkonaluminaten, Carbonsäurederivaten, Weichmachern, Oligomer- und Polymer-Vorstufen, Ionomeren, Borsäure und deren Metallsalze und Derivate, Zinkstannaten, Zinkhydroxystannaten oder Kombinationen hiervon.

In einer weiteren bevorzugten Ausführungsform liegt das Flammschutzmittel in Kombination mit Synergisten, insbesondere Organoclays (Nanoclays), Zinnverbindungen und Boraten, vor. Es ist ebenfalls bevorzugt, wenn das Flammschutzmittel ferner mindestens einen weiteren flammhemmenden Zusatz in einem Anteil bis zu 70 Gewichtsprozent, vorzugsweise 5 bis 60 Gewichtsprozent, stärker bevorzugt 10 bis 50 Gewichtsprozent, stärker bevorzugt 15 bis 40 Gewichtsprozent enthält.

Als weiterer flammhemmender Zusatz eignet sich insbesondere eine endotherm reagierende Substanz, vorzugsweise eine endotherm reagierende Substanz, ausgewählt aus der Gruppe, bestehend aus Aluminiumhydroxid, Boehmit, Gibbsit, Goethit, Magnesiumhydroxid, Huntit, Brucit oder Mischungen hiervon.

Die vorliegende Erfindung betrifft ferner die Verwendung des erfindungsgemäßen Flammschutzmittels als Flammhemmer für brennbare Materialien, insbesondere brennbare Baustoffe, Gummi, Spanplattenmaterial, Kunststoffe, insbesondere Kabelummantelungen, Kabelisolationsmasse oder Kabelfüllmassen-Compounds.

Weiterhin betrifft die vorliegende Erfindung ein brandgeschütztes Stoffsystem, umfassend ein brennbares Material und ein erfindungsgemäßes Flammschutzmittel.

Als brennbares Material kommt insbesondere ein Baustoff, ein Gummiprodukt, eine Spanplatte, eine Fassadenverkleidung oder ein Kunststoffprodukt, insbesondere eine Kabelummantelung, Kabelisolationsmasse oder ein Kabelfüllmassen-Compound, in Frage.

Das brandgeschützte Stoffsystem enthält das Flammschutzmittel vorzugsweise in einem Anteil von 3 bis 95 Gewichtsprozent, stärker bevorzugt 5 bis 90 Gewichtsprozent, stärker bevorzugt 10 bis 80 Gewichtsprozent, stärker bevorzugt 20 bis 75 Gewichtsprozent, stärker bevorzugt 25 bis 70 Gewichtsprozent, insbesondere 30 bis 60 Gewichtsprozent.

In einer Weiterbildung umfasst das in dem brandgeschützten System verwendete Flammschutzmittel den erfindungsgemäß modifizierten Rotschlamm in einem Anteil von 30 bis 100 Gewichtsprozent, vorzugsweise 40 bis 95 Gewichtsprozent, stärker bevorzugt 50 bis 90 Gewichtsprozent, stärker bevorzugt 60 bis 85 Gewichtsprozent, und der jeweils verbleibende Anteil von 0 bis 70 Gewichtsprozent, vorzugsweise 5 bis 60 Gewichtsprozent, stärker bevorzugt 10 bis 50 Gewichtsprozent, stärker bevorzugt 15 bis 40 Gewichtsprozent, wird durch eine weitere flammhemmende Zusammensetzung gebildet. Hierbei ist es vorteilhaft, wenn die weitere flammhemmende Zusammensetzung eine organische, nichttoxische endotherm reagierende Substanz wie APP, MC, MIC etc. und/oder einen Synergisten umfasst. Hierbei ist es ebenfalls vorteilhaft, wenn die weitere flammhemmende Zusammensetzung Salzhydrate, Hydroxide, Oxidhydrate und Carbonate, Oxycarbonate sowie Hydroxycarbonate umfasst.

Die vorliegende Erfindung betrifft ferner ein Verfahren zur Herstellung eines brandgeschützten Stoffsystems, umfassend die Schritte:

a) Bereitstellen eines brennbaren Materials,
b) Beschichten oder Vermengen des brennbaren Materials mit dem erfindungsgemäßen Flammschutzmittel, und dadurch
c) Erhalten des brandgeschützten Stoffsystems.

Hierbei ist es vorteilhaft, wenn das Flammschutzmittel vor dem Beschichten oder Vermengen des Schrittes b) physikalisch behandelt, insbesondere gemahlen oder desagglomeriert wird, vorzugsweise zusammen mit Synergisten, insbesondere Organoclays (Nanoclays), Zinnverbindungen und Boraten, und/oder mindestens einem weiteren flammhemmenden Zusatz.

Vorzugsweise wird das in Schritt b) genannte Flammschutzmittel einer Oberflächenmodifizierung unterzogen. Diese erfolgt vorzugsweise vor dem Beschichten oder Vermengen mit dem brennbaren Material.

Die Oberflächenmodifizierung des Flammschutzmittels umfasst vorzugsweise ein Versehen der Oberfläche des Flammschutzmittels mit einem Oberflächenmodifizierungsmittel, das aus der Gruppe, bestehend aus Organosilanen, Organotitanaten, Organo-Zirkonaluminaten, Carbonsäurederivaten, Weichmachern, Oligomer- und Polymer-Vorstufen, Ionomeren, Borsäure und deren Metallsalze und Derivate, Zinkstannaten, Zinkhydroxystannaten oder Kombinationen hiervon, ausgewählt ist.

Es ist ebenfalls vorteilhaft, wenn Synergisten, insbesondere bei der Verwendung des erfindungsgemäßen Flammschutzmittels in Elastomer-, Thermoplast- und Duromer-Systemen, in Form so genannter "Master Batches" (Wirkstoffkonzentraten) in flüssiger, pastöser oder Granulat-Form bei der Verarbeitung zugegeben werden.

Das erfindungsgemäße Verfahren zur Herstellung des anorganischen, halogenfreien Flammschutzmittels aus modifiziertem, karbonisiertem Rotschlamm (MKRS-HT) umfasst die Schritte:

a) Bereitstellen von Rotschlamm,
b) Reduzieren der in dem Rotschlamm enthaltenen Eisen(III)-Verbindungen in saurer Lösung zu Eisen(II)-Verbindungen,
c) Zugeben einer Carbonatverbindung zu der in Schritt b) erhaltenen Eisen(II)-Verbindungen enthaltenden Lösung, wobei Eisen(II)carbonat (Siderit) gebildet wird.

Bevorzugte Reduktionsmittel, die in Schritt b) eingesetzt werden können, sind schwefelhaltige Reduktionsmittel, insbesondere Natriumdithionit ($Na_2S_2O_4$) und Schwefeldioxid ($SO_2$).

Die Reduktion der in dem Rotschlamm enthaltenen Eisen(III)-Verbindungen zu Eisen(II)-Verbindungen gemäß Schritt b) findet vorzugsweise in schwach saurer Lösung, beispielsweise bei einem pH-Wert von 4 bis 6, insbesondere einem pH-Wert von 4,5 bis 5,5, statt.

Bevorzugte Carbonatverbindungen, die in Schritt c) eingesetzt werden können, sind Alkalicarbonate, Alkalihydrogencarbonate und Erdalkalicarbonate, insbesondere Natriumcarbonat ($Na_2CO_3$), Natriumhydrogencarbonat ($NaHCO_3$) und Calciumcarbonat ($CaCO_3$). Gegebenenfalls muss, wie es dem Fachmann aufgrund seines Fachwissens ersichtlich ist, der pH-Wert der in Schritt b) erhaltenen sauren Eisen(II)-Verbindungen enthaltenden Lösung vor dem Schritt c) in geeigneter Weise eingestellt werden, um durch Zugabe einer Carbonatverbindung Eisen(II)-carbonat (Siderit) zu erhalten.

Das erfindungsgemäße anorganische, halogenfreie Flammschutzmittel aus modifiziertem, karbonisiertem und rehydratisiertem Rotschlamm kann hergestellt werden, indem modifizierter, karbonisierter Rotschlamm (MKRS-HT), wie beispielsweise oben beschrieben, und modifizerter, rehydratisierter Rotschlamm (MR2S-NT), wie beispielsweise in der WO 2012/126487 A1, deren Offenbarung hiermit vollumfänglich aufgenommen wird, beschrieben, getrennt voneinander hergestellt werden und anschließend unter Erhalt des modifizierten, karbonisierten und rehydratisierten Rotschlamms vermischt werden.

Durch geeignete Reaktionsführung ist es aber auch möglich, im Rotschlamm sowohl eine Rehydratisierung als auch eine Karbonsierung unter Erhalt des modifizierten, karbonisierten und rehydratisierten Rotschlamms ablaufen zu lassen. Um die Modifizierung gezielt in die eine oder andere Richtung zu lenken, können geeignete technische Maßnahmen ergriffen werden, wie z.B. Reaktionsführung unter (oxidativ) inertem Prozeßgas, spezielle Trocknung mit unmittelbar anschließender Oberflächenmodifizierung ("Versiegelung") für eine bevorzugte Modifizierung in Richtung Siderit. Soll hingegen überwiegend Goethit entstehen, wird mit Luftsauerstoff oder alternativ Ozon gearbeitet, die die Fe(II)-Salzlösungen zu Fe(III)-Salzlösungen oxidieren. Mit Anheben des pH-Werts fällt Goethit an, der ebenfalls getrocknet und oberflächenversiegelt werden kann.

Die Oberflächenmodifizierung/Versiegelung dient darüber hinaus dazu eine optimale Anbindung der Polymermoleküle in der Interphase zum OHFR-Flammhemmer zu garantieren. Hierdurch werden die Compoundeigenschaften gezielt gesteuert.

Durch eine gezielte Prozessführung unter Inertgas oder mit Luftsauerstoff, Trocknung und Oberflächenmodifizierung ist die Herstellung eines für die gewünschte Verwendung maßgeschneiderten, karbonisierten und rehydratisierten Rotschlamms möglich.

Das so genannte inerte Prozessgas/ Schutzgas sollte von allen oxidierend wirkenden Komponenten, speziell (Luft-)Sauerstoff frei sein. Eingesetzt wird insbesondere ein zu gleichen Teilen aus Stickstoff und Argon (WIG- Schweiß-Qualität ist ausreichend) zusammengesetztes Prozessgas, welches im Kreislauf gefahren wird.

Das erfindungsgemäße anorganische , halogenfreie Flammschutzmittel aus modifiziertem, karbonisiertem und rehydratisierten RS , bzw. modifizierten, karbonisiertem RS kann auch hergestellt werden, indem RS nur rehydratisiert wird und Eisen(III bzw. Eisen (II)-Verbindungen isoliert zu Eisen(II)carbonat umgewandelt werden und beide Verbindungen anschließend in willkürlicher Form gemischt werden. Das isoliert hergestellte Eisen(II)carbonat kann in besonderer Form physikalisch und/oder chemisch behandelt werden, um spezielle anwendungstechnische Effekte zu erzielen. Die Endprodukte, können auf beiden Wegen chemisch identisch hergestellt werden.

Im Folgenden werden Beispiele, Versuche und weitere Ausführungsformen beschrieben, die allerdings nicht zur Beschränkung der vorliegenden Erfindung führen sollen. Vielmehr dienen sie der Verdeutlichung der erfindungsgemäßen Lehre und deren Vorteile.

Herstellung von modifiziertem Rotschlamm:

Beispiele

Beispiel 1

4 g Rotschlamm mit einem Fe2O3-Gehalt von 40 % (1,6 g Fe2O3 = 0,01 mol) wurden im Becherglas mit 60 ml konzentrierter Salzsäure (0,6 mol) versetzt und 24h bei Raumtemperatur gerührt.

Nach diesem Zeitraum konnte ein Rückstand von 3,2 g abgetrennt werden, d. h. 0,8 g Fe2O3 hatten sich aufgelöst (50 %). Bei längerem Rühren und höheren Temperaturen kann weiteres Fe2O3 aufgelöst werden.

Der PH-Wert der Filtratlösung wurde mit verdünnter NaOH (0,5 mol NaOH in 100 ml Wasser) auf 4,5 eingestellt. Danach wurden 0,05 mol Na2SO3 x 7 H2O (1,3 g) in 50 ml H2O zugegeben. Nach einigen Stunden wurde die gelbe Lösung nahezu farblos. Aus dieser Lösung wurden durch Zugabe von 0,8 g Na2CO3 1,2 g Fällungsprodukt erzeugt. Dieses Produkt bestand gemäß PXRD zu jeweils 50 % aus Siderit und Goethit. Nach längerem Zeitraum färbt sich das ausgefällte Produkt zunächst grünlich und dann braun, d. h. das Fe(II)carbonat hat sich an der Luft zu Fe(III)-Verbindungen oxidiert. Wird dagegen Sauerstoff ausgeschlossen, fällt überwiegend Siderit an, der langfristig stabil bleibt.

Es zeigt sich also, dass unter inerten Bedingungen Siderit ausgefällt wird, unter oxidativen Bedingungen am Ende Goethit. Zwischenstufen, die Siderit und Goethit enthalten, können jederzeit abgefangen und getrocknet und ggf. oberflächenversiegelt werden.

Beispiel 2

Die eingesetzten Geräte sind vorzugsweise ein entsprechend ausgerüsteter Sprühturm (von NIRO Atomizer, Copenhagen). Hierbei fällt das getrocknete und optional gleichzeitig oberflächenmodifizierte Material z. B. gemäß Oberflächenmodifizierung "A" (siehe unten) mikroskalig an. Falls aus anwendungstechnischen Gründen ein nanoskaliges Material benötigt wird, kann die Oberflächenbeschichtung nach dem Trocknen mittels eines Swirl Fluidizers in dem nach geschalteten Fluidmischer/Schnellmischer durchgeführt werden.

*Sprühturm:*

Im Sprühturm erfolgt vorzugsweise die Trocknung, die Einstellung der Kornverteilungskurve (Top-cut; d90, d50 und d10) und optional die Oberflächenmodifizierung des Materials.

Im hier dargestellten Fall, d.h. mit Oberflächenmodifizierung "A", wird dem einzutragenden Slurry mit einem Feststoffgehalt, welcher in weiten Grenzen variiert werden kann, von zum Beispiel 50 %, die entsprechende Menge an Amino-propyl-tris ethoxy-silan (1 Gew.% AMEO von Evonik/Degussa bezogen auf den Feststoffgehalt ; siehe Kapitel "Oberflächenmodifikationen") unter intensivem Rühren zugesetzt. Das Organosilan reagiert durch Hydrolyse zu einem Oligo-organosilanol, welches auf die Oberfläche des zu trocknenden Materials aufzieht und dort unter Bildung kovalenter Bindungen fixiert wird

(siehe Edwin S. Plueddeman, Silane Technology, Elsevier, NY, USA)

Zusätzlich ist dem Slurry 0.3 Gew.% (bezogen auf den Feststoffgehalt) DISPEX A 80 als Dispergier- und Verflüssigungsmittel, welches die Pumpbarkeit des Slurries erst ermöglicht, zugefügt.

Die Sekundärpartikelgröße (d.h. der gewünschte Agglomerationsgrad) wird durch die Variation von der Eintritts- (typischerweise zwischen 500 °C und 300 °C) und Austrittstemperatur (typischerweise zwischen 120 °C und 60 °C) des Prozessgases, der Sprühscheiben-Umdrehungszahl, der Zahl und Geometrie der Düsenöffnungen, des Durchsatzes pro Stunde an Slurry, in Grenzen auch über die Slurry-Konzentration (Feststoffgehalt) eingestellt.

Wird der Sprühturm, ohne die Aminosilan-Oberflächenmodifizierung verwendet, entsteht ein mikroskaliger MR2S-NT oder MKRS-HT mit optimiertem Goethit- oder Siderit-Gehalt (je nach Optimierungswunsch entsprechend der oben beschriebenen Prozessführung).

Optional wird in einer nach geschalteten Stiftmühle (Fa. Alpine) "desagglomeriert", d.h. die mittlere Teilchengröße auf eine Bandbreite von 1 bis 1,5 $\mu$m (d50) eingestellt.

Die Kornverteilungskurve entspricht in etwa der eines feinteilig gefällten Aluminumhydroxids, wie z.B. MARTINAL OL 104 (Martinswerk / Albemarle) oder SUPERFINE SF4ESD (Alcan Ltd.), oder der eines synthetischen Magnesiumhydroxids, wie z.B. MAGNIFIN H5 (Magnesit Prod. Gesellschaft).

Diese Kornverteilungskurve ermöglicht ein nahezu optimales Compoundieren in die meisten thermoplastischen und duroplastischen Polymersysteme sowie in Kautschuksysteme. Das gleiche trifft auf alle thermoplastischen Elastomer (TPE)-Systeme zu.

*Swirl Fluidizer:*

Im Swirl Fluidizer erfolgt vorzugsweise die Trocknung und die Einstellung eines nanoskaligen Produktes.

Die optionale Oberflächenmodifizierung wird ausschließlich im nach geschalteten Fluidmischer (Schnellmischer) vorgenommen.

Hierbei kann eine Vielzahl von Oberflächenmodifizierungsmitteln fester, flüssiger oder pastöser Konsistenz verwendet werden. Es ist auch eine in-situ Polymerisation auf der Oberfläche der OHFR-Systeme, wie MR2S-NT oder MKRS-HT, möglich.

Im Swirl Fluidizer wird unter den gleichen Prozessgasbedingungen wie im Sprühturm das erfindungsgemäße Material mittels einer frequenzgesteuerten Monoschnecke in den Reaktionsraum transportiert. Das entsprechend konfigurierte Werkzeug zerteilt das zu trocknende Material im Prozessgas, wobei vorwiegend nanoskalige Primärpartikel entstehen.

Durch den Durchsatz pro Stunde, die Eintritts- und Austrittstemperatur des Prozessgases, und die als Steuergröße gewählte Restfeuchte des erfindungsgemäßen Materials sowie die Konfiguration und die Umdrehungsgeschwindigkeit des Werkzeugs wird der Prozess gezielt so gesteuert, dass das Produkt nanoskalig anfällt.

Wenn eine Oberflächenmodifizierung durchgeführt werden soll, wird das trockene Material (Restfeuchte üblicherweise 0,05 %) über eine Zellradschleuse direkt in den nach geschalteten Fluidmischer dosiert und dort gemäß der Beschreibung "Oberflächenmodifizierung A ,B, C und D" beschichtet.

Hierbei wird die Austrittstemperatur des optimierten MR2S-NT oder MKRS-HT, (typischerweise 80 °C), welche sich im Fluidmischer auf ca. 50 °C Equilibrium abkühlt, dazu benutzt, den Oberflächenmodifizierungsprozess effektiver zu gestalten, da sich das Mischgut schneller auf die jeweilige Reaktionstemperatur aufheizt.

Der Kühlmischer kühlt das Produkt auf Raumtemperatur ab, so dass sofort ohne Zwischensilo-Lagerung abgesackt werden kann.

DTA- und TG-Analysen:

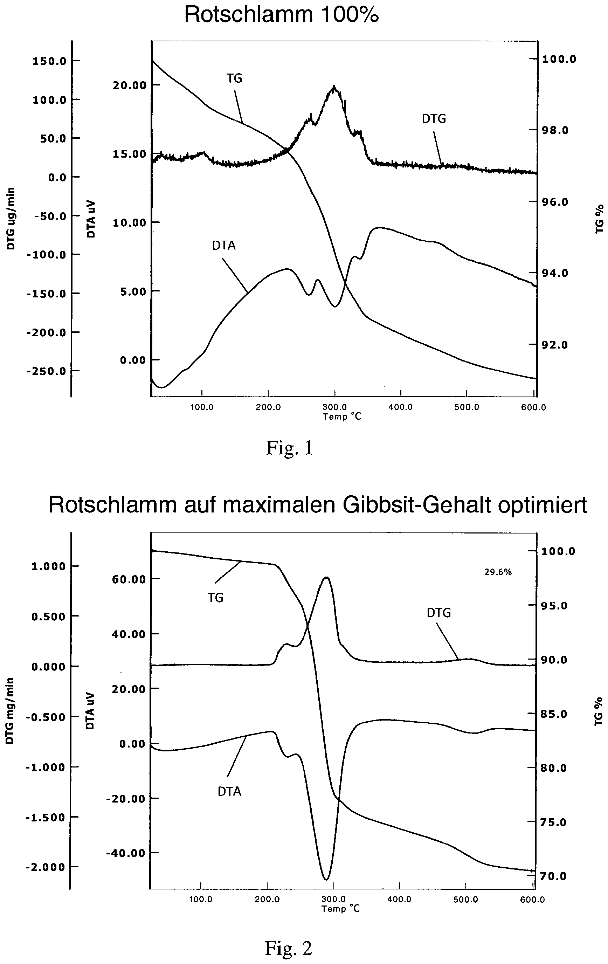

Figur 1 zeigt DTA- und TG-Kurven von Rotschlamm (Vergleichsbeispiel). Zwischen 220 °C und 350 °C sind endotherme Reaktionen sichtbar, die auf Restgehalte von Gibbsit/Boehmit und Goethit zurückzuführen sind. Im Rotschlamm sind die Zersetzungsintervalle von Hydroxiden/Oxidhydraten des Aluminiums und des Eisens in etwas höhere Temperaturbereiche verschoben.

Figur 2 zeigt DTA- und TG-Kurven von Rotschlamm, der in Richtung Gibbsit rehydratisiert worden ist (Referenzbeispiel). Dabei ist zusätzlich auch Goethit entstanden. Die endotherme Reaktion findet zwischen 210°C und 350°C statt.

Figur 3 zeigt DTA- und TG-Kurven von Rotschlamm, der in Richtung Goethit rehydratisiert worden ist (Referenzbeispiel). Dabei ist zusätzlich auch Gibbsit entstanden. Die endotherme Reaktion findet zwischen 210°C und 350°C statt.

Figur 4 zeigt DTA und TG-Kurven von Rotschlamm, der in Richtung Siderit karbonisiert worden ist (erfindungsgemäßes Beispiel: modifizierter, karbonisierter Rotschlamm (MKRS-HT)). Die endotherme Reaktion findet zwischen 350°C und 500°C statt, also im Hochtemperaturbereich (HT).

Figur 5 zeigt DTA- und TG-Kurven von Rotschlamm, der sowohl in Richtung Goethit rehydratisiert als auch in Richtung Siderit karbonisiert worden ist (erfindungsgemäßes Beispiel: modifizierter, karbonisierter und rehydratisierter Rotschlamm (MKRS-HT/MR2S-NT)). Die endotherme Reaktion findet für die Hydroxide/Oxidhydrate Goethit/Gibbsit zwischen 220°C und 350°C im Niedrigtemperaturbereich (NT) und für Siderit zwischen ca. 350°C - 500°C im Hochtemperaturbereich (HT) statt. Produkte dieser Art zeigen also endotherme Reaktionen von ca. 220°C bis 500°C.

Röntgenographische Analysen:

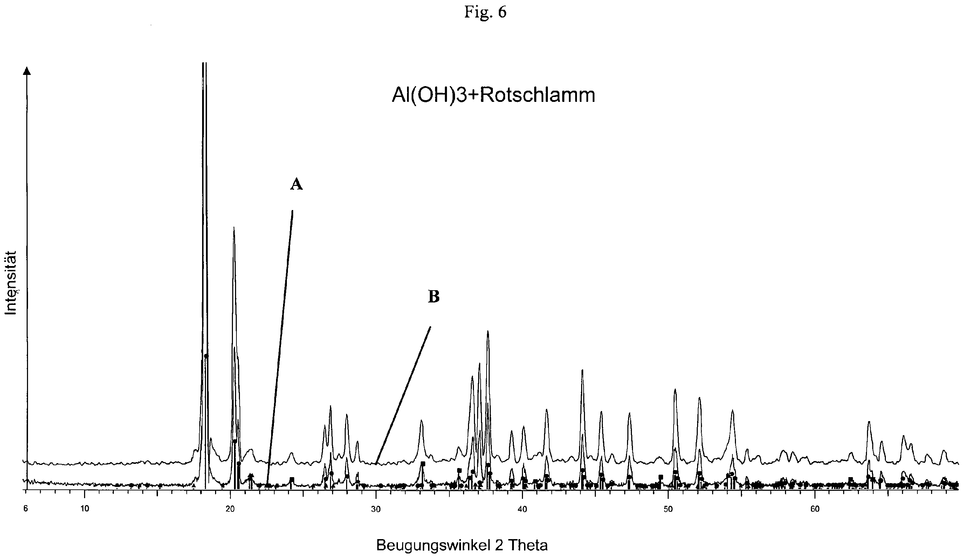

Figur 6 (Diagramm 1) zeigt das Röntgendiagramm von Rotschlamm, der in Richtung Gibbsit rehydratisiert worden ist (vgl. DTA- und TG-Kurven Figur 2). Die Liniendiagramme zeigen:

Liniendiagramm A:

Typ: 2Th/Th locked - Start: 5.000 ° - End: 70.000 ° - Step: 0.040 °- Step time: 10. s - Temp.: 25 °C (Room) - Time Started: 15 s - 2-Theta: 5.000 °- Theta: 2.500 °- Chi: 0.00 °- Phi: 0.00 °-X: 0.0 mm Operations: Import

Liniendiagramm B:

Typ: 2Th/Th locked - Start: 5.000 °- End: 70.000 °- Step: 0.040 °- Step time: 10. s - Temp.: 25 °C (Room) - Time Started: 15 s - 2-Theta: 5.000 °- Theta: 2.500 °- Chi: 0.00 °- Phi: 0.00 °-X: 0.0 mm Operations: Y Scale Add 125 I Background 0.000,1.000 I Y Scale Mul 2.000 I Smooth 0,161 I Import

Legende:

■ 00 033 0664 (*) - Hematit, syn - Fe203 - Y: 1.36 % - d x by: 1. - WL: 1.5406 - Rhombo.H.axes - a 5.03560 - b 5.03560 - c 13.74890 - alpha 90.000 - beta 90.000 - gamma 120.000 - Primitiv - R-3c (167) - 6 - 301.926 - I/Ic PDF
● 01-070-2038 (C) - Gibbsit - Al(OH)3 - Y: 7.80% - d x by: 1. - WL: 1.5406 - Monoclinic - a 8.68400 - b 5.07800 - c 9.73600 - alpha 90.000 - beta 94.540 - gamma 90.000 - Primitiv - P21/n (14) - 8 - 427.985 - I/Ic PDF 1.8 - F30=6
▲ 00-049-0007 (*) - Natriumaluminiumsilikat - Na1.15A11.15si0.8504 - Y: 0.65 % - d x by: 1. - WL: 1.5406 - Orthorhombic - a 10.30800 - b 14.22600 - c 10.21400 - alpha 90.000 - beta 90.000 - gamma 90.000 - Primitiv - Pc21b

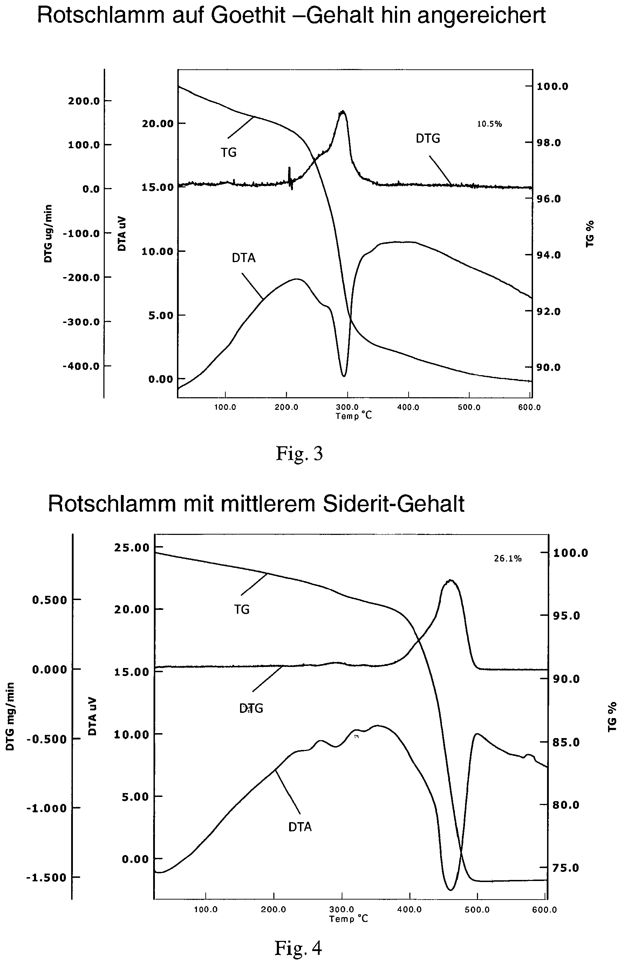

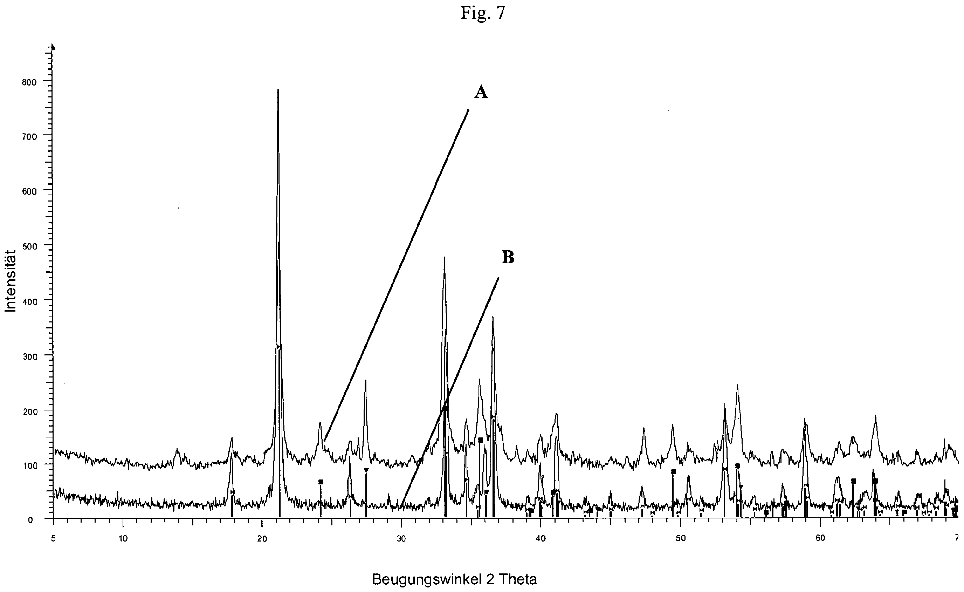

Figur 7 (Diagramm 2) zeigt das Röntgendiagramm von Rotschlamm, der in Richtung Goethit rehydratisiert worden ist (vgl. DTA- und TG-Kurven Figur 3). Die Liniendiagramme zeigen:

Liniendiagramm A:

Typ: PSD fast scan - Start: 5.000 °- End: 70.000 ° - Step: 0.040 °- Step time: 1. s - Temp.: 25 °C (Room) - Time Started: 17 s - 2 Theta: 5.000 ° -Theta: 1.544 °- Phi: 0.00 °- Aux1: 0 0Aux1: 0.0 - Au Operations: Y Scale Add 83 ~ Range Op. A+B Import

Liniendiagramm B:

Typ: 2Th/Th locked - Start: 5.000 °- End: 70.000 ° - Step: 0.040 °- Step time: 10. s - Temp.: 25 °C (Room) - Time Started: 15 s - 2-Theta: 5.000 ° - Theta: 2.500 °- Chi: 0.00 °- Phi: 0.00 ° Operations: Import

Legende:

■ 00-033-0664 (*) - Hematit, syn - Fe203 - Y: 21.62 % - d x by: 1. - WL: 1.5406 - Rhombo.H.axes - a 5.03560 - b 5.03560 - c 13.74890 - alpha 90.000 - beta 90.000 - gamma 120.000 - Primitive - R-3c (167) - 6 - 301.9
▼ 00-021-1276 (*) - Rutil, syn - Ti02 - Y: 8.94 % - d x by: 1. - WL: 1.5406 - Tetragonal - a 4.59330 - b 4.59330 - c 2.95920 - alpha 90.000 - beta 90.000 - gamma 90.000 - Primitive - P42/mnm (136) - 2 - 62.4344 - I/ Ic
▶◀ 01-081-0463 (C) - Goethit, syn - FeO(OH) - Y: 34.21 % - d x by: 1. - WL: 1.5406 - Orthorhombic - a 4.61580- b 9.95450 - c 3.02330 - alpha 90.000 - beta 90.000 - gamma 90.000- Primitive - Pbnm (62) - 4 - 138.915

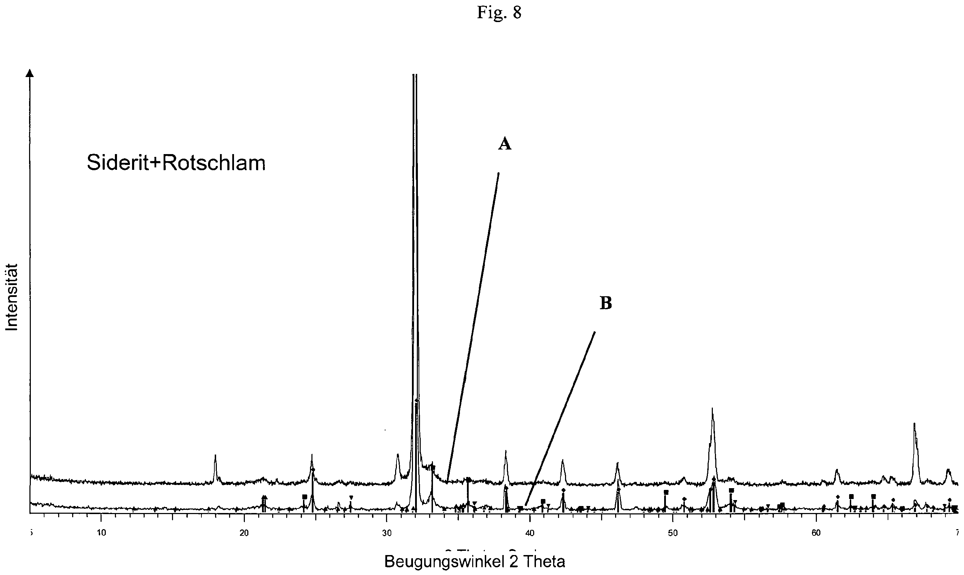

Figur 8 (Diagramm 3) zeigt das Röntgendiagramm von Rotschlamm, der in Richtung Siderit karbonisiert worden ist (vgl. DTA- und TG-Kurven Figur 4). Die Liniendiagramme zeigen:

Liniendiagramm A:

Typ: 2Th/Th locked - Start: 5.000 °- End: 70.000 °- Step: 0.020 °- Step time: 16. s - Temp.: 25 °C (Room) - Time Started: 15 s - 2-Theta: 5.000 °- Theta: 2.500 °- Chi: 0.00 °- Phi: 0.00 °- X: 0 Operations: Y Scale Add 167 I Import

Liniendiagramm B:

Typ: 2Th/Th locked - Start: 5.000 °- End: 70.000 °- Step: 0.020 °- Step time: 10. s - Temp.: 25 °C (Room) - Time Started: 16 s - 2-Theta: 5.000 ° - Theta: 2.500 °- Chi: 0.00 °- Phi: 0.00 °- X: 0. 0 mm - Y: Operations: Import

Legende:

■ 00-033-0664 (*) - Hematit, syn - Fe2O3 - Y: 1.83 % - d x by: 1. - WL: 1.5406 - Rhombo.H.axes - a 5.03560 - b 5.03560 - c 13.74890 - alpha 90.000 - beta 90.000 - gamma 120.000 - Primitiv - R-3c (167) - 6 - 301 .926 - I/Ic PDF
♦ 01-083-1764 (C) - Siderit - Fe(CO3) - Y: 4.79 % - d x by: 1. - WL: 1.5406 - Rhombo.H.axes - a 4.691 60 - b 4.69160 - c 15.37960 - alpha 90.000 - beta 90.000 - gamma 120.000 - Primitiv - R-3c (167) - 6 - 293.169 - I/Ic PDF 3.6
▲ 00-049-0007 (*) - Natriumaluminiumsilikat - Na1.15A11.15Si0.8504 - Y: 0.53 % - d x by: 1. - WL: 1.5406 - Orthorhombic - a 10.30800 - b 14.22600 - c 10.21400 - alpha 90.000 - beta 90.000 - gamma 90.000 - Primitive - Pc21b (
▼ 00-021-1276 (*) - Rutil, syn - Ti02 - Y: 0.49 % - d x by: 1. - WL: 1.5406 - Tetragonal - a 4.59330 - b 4.59330 - c 2.95920 - alpha 90.000 - beta 90.000 - gamma 90.000 - Primitiv - P42/mnm (136) - 2 - 62.4344 - I/Ic PDF 3.4 - F3

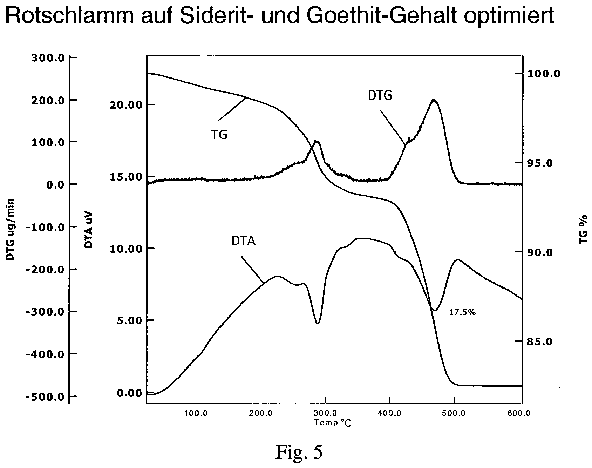

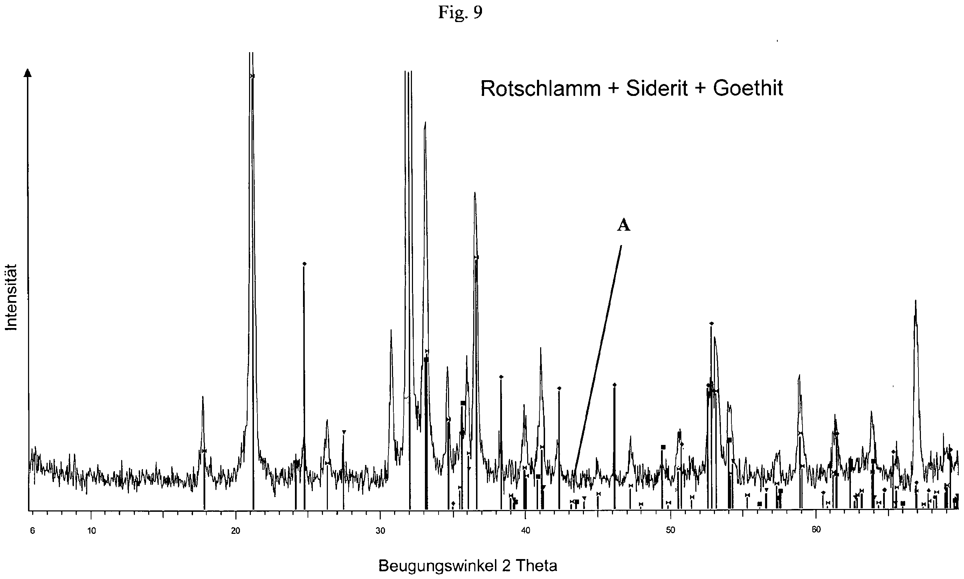

Figur 9 (Diagramm 4) zeigt das Röntgendiagramm von Rotschlamm, der sowohl in Richtung Siderit karbonisiert wie in Richtung Goethit rehydratisiert worden ist (vgl. DTA- und TG-Kurven Figur 5). Das Liniendiagramm zeigt:

Liniendiagramm A:

33% Rotschlamm+33% Siderit+33% Goethit - Typ: 2Th/Th locked - Start: 5.000 °- End: 70.000 ° - Step: 0.040 °- Step time: 10. s - Temp.: 25 °C (Room) - Time Started: 14 s - 2-Theta: 5.000 ° - Theta Operations: Import

Legende:

■ 00-033-0664 (*) - Hematit, syn - Fe203- Y: 1.36 %,- d x by: 1. - WL: 1.5406-Rhombo.H.axes - a 5.03560- b 5.03560- c 13.74890 - alpha 90.000 - beta 90.000 - gamma 120.000- Primitiv - R 3c (167) -6- 301.926- I/Ic PDF

♦ 01-083-1764 (C) - Siderit - Fe(C03) - Y: 6.22 % - d x by: 1. - WL: 1.5406 - Rhombo.H.axes - a 4.691 60 - b 4.69160 - c 15.37960 - alpha 90.000 - beta 90.000 - gamma 120.000 - Primitiv - R-3c (167) - 6 - 293.169 - I/Ic PDF 3.6

▼ 00-021-1276 (*) - Rutil, syn - Ti02 - Y: 0.69 % - d x by: 1. - WL: 1.5406 - Tetragonal - a 4.59330 - b 4.59330 - c 2.95920 - alpha 90.000 - beta 90.000 - gamma 90.000 - Primitive - P42/mnm (136) - 2 - 62.4344 - I/Ic PDF 3.4 - S

▶◀ 01-081-0463 (C) - Goethit, syn - FeO(OH) - Y: 3.95 % - d x by: 1. - WL: 1.5406 - Orthorhombic - a 4.61580 - b 9.95450 - c 3.02330 - alpha 90.000 - beta 90.000 - gamma 90.000 - Primitiv - Pbnm (62) - 4 - 138.91 5 - I/Ic PDF 2.

Diskussion

Die Standardmethode zur qualitativen und quantitativen Bestimmung des Phasenbestandes von pulverförmigen Proben ist die Röntgenpulverdiffraktometrie. Sie ist eine vielseitig anwendbare, zerstörungsfreie Methode, die auch detaillierte Informationen über den atomaren Aufbau und die Kristallstruktur sowohl von natürlich vorkommenden, als auch synthetisch hergestellten Materialien liefern kann. Dabei zeigt jedes kristalline Material bei Beleuchtung mit Röntgenstrahlung ein einzigartiges und charakteristisches Beugungsmuster, das durch Größe, Symmetrie und atomaren Aufbau definiert ist und zur eindeutigen Identifikation herangezogen werden kann.

Unter dem Begriff "Thermische Analyse" werden Methoden zusammengefasst, die chemische und/oder physikalische Eigenschaften einer Verbindung als Funktion der Temperatur messen. Hierbei wird bei der Thermogravimetrie (TG) die Massenänderung einer Probe in Abhängigkeit von der Temperatur und/oder der Zeit gemessen. Dazu dient eine in das Messgerät integrierte Thermowaage. Hingegen nutzt die Differenz-Thermoanalyse (DTA) den charakteristischen Wärmeenergieumsatz bei einem Phasenübergang zur quantitativen und qualitativen Analyse. Hierbei wird die Temperatur der Probe mit der einer Referenzsubstanz verglichen.

Die Röntgendiagramme und die DTA- und TG-Kurven beweisen, dass Rotschlamm sowohl rehydratisiert wie auch karbonisiert werden kann. In allen Fällen wurde Rotschlamm verwendet, der beim Rohraufschluß (270 °C/60 bar) anfällt.

Bei der Karbonisierung entsteht hauptsächlich Siderit, bei der Rehydratisierung hauptsächlich Gibbsit/Boehmit und vor allem Goethit.

Bei der Herstellung dieser Produkte wurde Rotschlamm im ersten Schritt in saurer Lösung reduziert. Im zweiten Schritt wurde aus dieser Lösung unter oxidativ inerten Bedingungen durch Zusatz von $NaHCO_3$, $Na_2CO_3$ oder $CaCO_3$ Siderit ausgefällt. Soll in Richtung Gibbsit oder Goethit optimiert werden, werden durch Anhebung des pH-Wertes unter oxidierenden Bedingungen Goethit und Gibbsit ausgefällt.

Insgesamt und erfindungsgemäß können also aus Rotschlamm durch Rehydratisierung oder Karbonisierung OHFR-Systeme hergestellt werden, die im Bereich 210°C bis 310°C , bzw. 350°C bis 500°C ihre endotherme flammhemmende Wirkung entfalten.

Durch Hintereinanderschaltung von Karbonisierung und Rehydratisierung oder durch Mischung von karbonisiertem und rehydratisiertem Rotschlamm können also maßgeschneiderte OHFR-Produkte für alle Typen von Kunststoffsystemen hergestellt werden sowohl im Niedrigtemperaturbereich als auch im Hochtemperaturbereich.

Aus den Figuren wird ersichtlich, wie sich modifizerter rehydratisierter oder modifizierter karbonisierter Rotschlamm, der entweder überwiegend in Richtung Gibbsit / Boehmit und Goethit / Lepidocrocit / Akaganeit oder überwiegend in Richtung Siderit modifiziert worden ist, thermisch zersetzt und in welchen Temperaturbereichen.

Aus den Hydroxiden bzw. den Oxidhydraten des Aluminiums und des Eisens entstehen hierbei die jeweiligen Oxide und Wasser, aus Eisen(II)carbonat entsteht das entsprechende Oxid und $CO_2$. Das entstehende $CO_2$ wirkt zusätzlich feuerlöschend.

Insbesondere Siderit zersetzt sich in einem Temperaturintervall, bei dem die Hydroxide und Oxidhydrate schon längst zersetzt sind und somit keinen effektiven Beitrag zum Flammschutz mehr leisten können.

Die deutlich höhere Zersetzungstemperatur von Siderit ist insofern vorteilhaft, als beim Test nach UL 94 Vertikal nach der kompletten Dehydratisierung der Hydroxide und Oxidhydrate der Brandvorgang wieder aufleben kann. Mit auf hohen Sideritgehalt optimiertem MKRS-HT steht somit für höhere Temperaturintervalle ein geeigneter OHFR-Flammhemmer zur Verfügung.

Insgesamt bietet sich die Möglichkeit ein FR-System zu entwickeln, bei dem durch geschickte Kombination von Niedertemperatur-OHFR-Agenzien, wie ATH oder Goethit, Lepidocrocit, Akaganeit, und Hochtemperatur-OHFR-Agenzien, wie vorzugsweise Eisen(II)carbonat, der erforderliche Flammschutz, respektive die systemimmanenten Brandausbreitung so gesteuert werden kann, dass für jedes Polymer- , respektive FR-Compound-System der optimale OHFR Effekt erreicht wird.

Mit modifiziertem rehydratisiertem Rotschlamm (MR2S-NT) und/oder karbonisiertem Rotschlamm (MKRS-HT) lassen sich also erfindungsgemäß "maßgeschneiderte" OHFR-Materialien zielgerichtet und hochspezifisch synthetisieren. Es ist auch möglich, durch Mischen von in Richtung MR2S-NT oder in Richtung MKRS-HT modifizierten Rotschlämmen solche Produkte für den Flammschutz herzustellen.

Die Wirkung kann noch durch die beschriebene Oberflächenmodifizierung und Kombination mit den beschriebenen Synergisten, insbesondere Nanoclays, intensiviert werden.

Grundsätzlich ist festzustellen, dass die Verarbeitungstemperatur der flammfest auszurüstenden Materialsysteme bestimmt, welche Produkte der modifizierte Rotschlamm enthalten soll. Im Bereich des Hochtemperaturflammschutzes sind Produkte für den Niedertemperaturflammschutz wie ATH, Goethit, Lepidocrocit und Akaganeit ungeeignet, da sich diese Produkte bereits bei der Verarbeitung zersetzen. Durch eine entsprechende Steuerung des Rehydratisierungsprozesses bzw. Karbonisierungsprozesses lassen sich erfindungsgemäß spezifisch und gezielt rehydratisierte und/oder karbonisierte Rotschlämme herstellen, die die gewünschten Bedingungen erfüllen. Grundsätzlich stören umgekehrt beim Niedertemperaturflammschutz die Produkte des Hochtemperaturflammschutzes nicht, da die Zersetzungstemperatur dieser Materialien weit über der Polymerverarbeitungstemperatur liegt. Es ist im Gegenteil vorteilhaft, da die Zersetzung des Siderit-optimierten MKRS-HT das Flammschutzpotential erheblich erhöht.

Oberflächenmodifizierung :

Oberflächenmodifizierungen haben wesentlichen Einfluss auf die Qualität der FR-Systeme und auf ihre Verarbeitbarkeit bei der Compoundierung. Darüber hinaus unterstützen ausgewählte Oberflächenmodifizierungen den FR-Effekt und die Anbindung in der Interphase (Kompatibilisierungseffekt).

Folgende Rezepturen kommen beispielhaft für eine Oberflächenmodifizierung zum Einsatz:

*1) Oberflächenmodifizierung A:*

1 Gewichts% n-Aminopropyl-triethoxy-silan (AMEO) von Degussa / Evonik, bezogen auf die Gesamtmasse der Nicht-Polymerkomponenten

*2) Oberflächenmodifizierung B:*

1 Gewichts% EDENOR C 12 / 98-100 (Henkel, Deutschland), 1,5 Gewichts% SFR 100 (General Electric Silicones, Schenectady, NY, USA), bezogen auf die Gesamtmasse der Nicht-Polymerkomponenten

*3) Oberflächenmodifizierung C:*

| | |
|---|---|
| 2 Gewichts% | Trilene 66 (Uniroyal) (flüssiges EP(D)M Polymer), |
| 1 Gewichts% | Unichema 4900 (Stearic acid) Unichema, |
| 1 Gewichts% | Levapren 600 (EVA-Copolymer), |

bezogen auf die Gesamtmasse der Nicht-Polymerkomponenten

*4) Oberflächenmodifizierung D:*

| | |
|---|---|
| 1 Gewichts % | Lithsolvent PL (Fa.Keller& Bohacek, Düsseldorf, Deutschland), |
| 2 Gewichts % | Epikote Resin 1163, |
| 1 Gewichts % | Edenor C 14 (Henkel), |

bezogen auf die Gesamtmasse der Nicht-Polymerkomponenten

Für die Oberflächenmodifizierung wird ein Fluid- oder auch Turbinenmischer verwendet, der ein mehrstöckiges variables Werkzeug hat und dessen Außenmantel temperierbar ist.

Die Reaktionsadditive werden entweder zu Beginn des Mischzyklus mit dem zu modifizierenden Material in den stehenden oder in den langsam anlaufenden Turbomischer in den Misch-/Reaktionsraum dosiert. Wenn die Modifizierungsadditive flüssig bis pastös sein sollten, so werden diese in die Trombe des Mischers dosiert.

Nach Beendigung der Reaktion wird das heiße Material im nach geschalteten Kühlmischer schonend auf Raum- bzw. Absacktemperatur (typischerweise 35 °C bis 23 °C) herabgekühlt. Dieses Material wird pulvertechnologisch charakterisiert und danach in den unten beschriebenen Polymer-Compounds eingesetzt.

Die beschriebenen erfindungsgemäßen OHFR-Materialien sind beliebig lange haltbar und haben in den beschriebenen Modifikationen keinen chemisch erkennbaren Verfallszeitraum, sachgerechte trockene Lagerung in möglichst verschlossenen Original-Verpackungen vorausgesetzt. Durch die Korngrößenverteilung besteht nicht wie bei den aus einzelnen Komponenten vermengten FR-Kompositionen mit unterschiedlichen mittleren Korngrößenwerten (d50) die permanente Gefahr der partiellen oder totalen Entmischung durch z. B. Transportvorgänge oder beim Austrag aus dem Silo oder der Waage am Compoundieraggregat. Die zuvor beschriebenen erfindungsgemäßen OHFR -Materialien können bei den jeweiligen Compoundierungen wie sie sind, d.h. beispielsweise ohne Vortrocknung, eingesetzt werden. Speziell die oberflächenmodifizierten Varianten des erfindungsgemäßen OHFR-Materials nehmen keine Feuchtigkeit aus der Umgebungsluft auf und können somit unverändert/ohne Vortrocknung eingesetzt werden.

Verarbeitungsverfahren der erfindungsgemäßen Materialien zu den in den Beispielen genannten OHFR-Compounds:

Eingesetzte Versuchsmaterialien:

*Polymere,*

- EVA Copolymer "ESCORENE ULTRA UL 00119" von ExxonMobil
- PP Random Copolymer "VESTOLENE PP 8400"
- Polyamid 6 "ULTRAMID B3L" von BASF
- PVC DS 7060 von ICI UK

*Flammhemmer*

- Aluminiumhydroxid "SUPERFINE SF4 ESD" von Alcan Chemicals Ltd. Burntisland, Scotland,UK (Nullprobe)
- Magnesiumhydroxid "Magnifin H 5" von Veitscher Magnesit Produktionsgesellschaft, Breitenau, Austria (Nullprobe)
- Pentabromdiphenylether p.a. und Antimontrioxid p.a. (Nullprobe)
- MR2S-NT (Nullproben)
- MKRS-HT (erfindungsgemäße Probe)
- MR2S-NT/MKRS-HT (erfindungsgemäße Probe)

*Additive/Synergisten*

- Nanoclay: "Bentone 104" von Elementis Inc., USA oder "Nanofil SE 3000" von Südchemie / Rockwood Clay Additives GmbH, Deutschland
- Zinkstannat "FLAMTARD S" von Joseph Storey, UK

*Compoundieraggregate*

Alle angeführten Polymercompounds wurden, wie in den jeweiligen Tabellen indiziert, auf den folgenden Compoundieraggregaten zu den entsprechenden Formmassen verarbeitet:

1) BUSS-Koaxial Kneter (MDK 46 E, 15 L/D mit GS 70 3,5 D) mit einem mittleren Durchsatz von 15 bis 20 kg / h

2) Gleichlaufender Zweiwellen(-schnecken)-Extruder (DSE oder SSE) Werner & Pfleiderer ZSK 25 mit einer mittleren Durchsatzleistung von 12 bis 25 kg/h oder Leistritz GL 50 mm mit 44 L/D mit einer mittleren Durchsatzleistung von 60 bis 250 kg/h.

*Dosierequipment*

Gravimetrische Waagen (*Loss-in-weight feeder*) auf allen Aufgabestationen für Polymer, Additive / Stabilisatoren und OHFR-Agenzien sowohl im Haupteinzug (ELS 1 beim Buss-Ko-Kneter) als auch "downstream" wobei die Polymergranulat-Waage als Masterwaage fungiert.
Die OHFR-Agenzien werden im Split-Feed-Modus jeweils über die drei Dosierstationen verteilt in den Polymerstrom zudosiert.

Die in Form von Granulat vorliegenden Compounds werden anschließend sowohl mittels Spritzguß als auch mittels Extrusion zu den entsprechenden Prüfkörpern nach DIN / ISO und ASTM verarbeitet und anschließend getestet. Die Prüfkörper für den Test des spezifischen Durchgangswiderstand werden aus einem Walzfell-Rohling hergestellt durch Aufschmelzen des Granulats auf einer temperierten Labor-Doppelwalze in einer beheizten/kühlbaren Plattenpresse. Vor den jeweiligen Tests werden die fertigen Prüfkörper im Norm-Raumklima equilibriert.

*Prüfungen*

| | |
|---|---|
| Zugfestigkeit [MPa] DIN EN ISO 527 | (hier genannt ZF) |
| Zug-E-Modul [MPa] DIN EN ISO 527 | (hier genannt E-Mod) |
| Reißdehnung [m/m] DIN EN ISO 527 | (hier genannt EL) |
| Reißfestigkeit [MPa] DIN ISO 527 | (hier genannt RF) |
| Schlagzähigkeit [kg/qm] DIN EN ISO 8256 | (hier genannt a(n)) |
| Sauerstoffindex [%] DIN EN ISO 4589-2 | (hier genannt LOI) |
| Charpy-Schlagzähigkeit [kg/qm] DIN EN ISO 179 | (hier genannt a(k)) |
| UL 94 Vertikal nach IEC/DIN 60695-10/-11/-20 und CSA C 22.2 | |
| Cone-Calorimeter nach ISO 5660-1/ASTM E 1354 | |
| Spezifischer Durchgangswiderstand DIN ISO 53482 [$\Omega$, x cm] | (hier genannt SDW) |
| MFI (Melt-Flow-Index) bei X°(C) und Belastungsgewicht y (kg) | in (g/10 Minuten) |

Hier bei EVA /PE normalerweise 190°C bei 5 kg oder bei 10 kg für schwere fließende Polymere Bei PP normalerweise bei 230°C und 2,16 kg oder 5 kg Belastung für die schwerer fließenden Extrusionstypen

In Tabelle 4 werden beispielhaft die in Europa für Kabelcompounds/Kabelmäntel üblichen Minimalforderungen aufgeführt.

**Tabelle 4:**

| | |
|---|---|
| Rating der Leiter-Temperatur | 90°C |
| Zugfestigkeit | > 10 MPa |
| Reissdehnung | > 1,5 m/m (= 150%) |
| Wasseraufnahme | max. 5 % (24h bei 100°C) |

Generell lassen sich alle Varianten des erfindungsgemäßen OHFR-Materials auf allen Verarbeitungsmaschinen/Compoundieraggregaten, die in der (Kunststoff-)Industrie für die Herstellung (hoch)gefüllter Polymercompounds verwandt werden, herstellen, wie z. B. (Banbury-)Innenmischer; Doppelwalz-Werke; Innenmischer; Farrel Continuous Mixer (FCM); Planetwellen-Extruder; SSE (Single Screw Extruder) mit Schnecken, die eine effektive Homogenisierung ermöglichen (Maddox-Mischkopf, Sperr-Ringe); Intensiv-Mischer.

Infolge der hohen Schüttdichte (UTBD) sowohl der Niedertemperatur- als auch der Hochtemperaturvariante des modifizierten RS und der extrem guten Rieselfähigkeit lassen sich die Materialien exzellent sowohl mit konventionellem volumetrischen als auch (vorzugsweise) mit gravimetrischen Dosierequipment (sog. "loss-in-weight feeder" beispielsweise von K-Tron-Soder oder Brabender) in die Compoundiermaschine zugeben.

**Beispiele**

Beispiele für EVA:

*0) Basisrezeptur als Nullprobe*

Rezeptur:

EVA 00119     40%

(fortgesetzt)

| ATH | 60% |
|---|---|

Ergebnisse:

| ZF: | 8,9 |
|---|---|
| RF: | 6,5 |
| EL: | 1,8 |
| SDW: | E 13 |
| MFI (190 /10): | 1,6 |
| UL 94 V(3,2 mm): | V-0 |
| LOI: | 28 |

Kommentar:

Diese Rezeptur entspricht dem akzeptierten Standard innerhalb der Kabelindustrie und ist die Vergleichsbasis für die Beispiele im Polymersystem PE/EVA.

*1)*

Rezeptur:

| EVA | 40% |
|---|---|
| MKRS-HT | 60% |

Ergebnisse:

| ZF: | 9,8 |
|---|---|
| EL: | 1,6 |
| SDW: | E 14/ E 12 |
| UL 94 V (3,2mm): | (V-2)* |
| LOI: | 26 |
| MFI (190/10): | 1,4 |
| *: das Nachglühen ist zu lang, folglich ist die Einstufung nach UL 94 vertikal : n.e. (nicht erfüllt) | |

Kommentar:

In dieser Rezeptur kommt ausschließlich der modifizierte karbonisierte RS (MKRS-HT) zum Einsatz. Die mechanischen Werte entsprechen dem Standard. Das Nachglühen kann durch Zusatz entsprechender Synergisten - wie z.B. Zinkstannat, Borate, etc. - unterdrückt werden.

2)

Rezeptur:

| EVA | 40% |
|---|---|

(fortgesetzt)

MKRS -HT    60%; oberflächenmodifiziert mit Beschichtung "D"

Ergebnisse:

| | |
|---|---|
| ZF: | 14,4 |
| EL: | 1,5 |
| SDW: | E 15 / E 14 |
| UL 94 V (3,2 mm): | V-1 |
| LOI: | 29 |
| MFI (190/10): | 2,3 |

Kommentar:

In dieser Rezeptur kommt ausschließlich modifizierter karbonisierter RS (MKRS-HT) zum Einsatz mit der Oberflächenmodifizierung nach Rezeptur "D". Die mechanischen Werte sind im Vergleich zum Standard sehr gut, die elektrischen Werte sind ebenfalls sehr gut, die Verarbeitbarkeit ist signifikant verbessert (um den Faktor 2). Der Flammschutz ist ebenfalls verbessert. Das Compound ist für sehr viele W&C Anwendungen verwendbar.

*3)*

Rezeptur:

| | |
|---|---|
| EVA | 35% |
| MR2S -NT | 30% |
| MKRS-HT | 30% |
| Nanoclay | 5% |

Die Mischung von MRRS und Nanoclay ist mit der Oberflächenmodifizierung "A" versehen.

Ergebnisse:

| | |
|---|---|
| ZF: | 16,6 |
| EL: | 3,41 |
| E-Mod. : | 189 |
| SDW: | E15/E15 |
| UL 94 V (3,2,mm): | V-0 |
| LOI: | 28 |

Kommentar:

In dieser Rezeptur kommt eine zielgerichtete Mischung aus modifiziertem rehydratisiertem RS (MR2S-NT) und modifiziertem karbonisiertem RS (MKRS-HT), also ein modifizierter, karbonisierter und rehydratisierter Rotschlamm, mit der Oberflächenmodifizierung "A" zum Einsatz. Die mechanischen und elektrischen Werte sind sehr gut. Es zeigt einen hervorragenden Wert für den Spezifischen Durchgangswiderstand. Die Flammfestigkeit entspricht dem eines vergleichbaren ATH-flammgeschützten Compounds.

*4)*

Rezeptur:

| | |
|---|---|
| EVA | 40% |
| MKRS-HT | 26% |
| MDH | 26% |
| Nanoclay | 5% |
| Flamtard S | 3% |

Alle Nicht-Polymerkomponenten werden mit der Oberflächenmodifikation "C" versehen.

Ergebnisse:

| | |
|---|---|
| ZF: | 15 |
| EL: | 1,75 |
| SDW: | E 15/ E 14 |
| UL 94V(1,6 mm): | V-0 |
| LOI: | 49 |

Kommentar:

In dieser Rezeptur wird modifizierter karbonisierter RS (MKRS-HT) in zielgerichteter Kombination mit einem konventionellen OHFR-Füllstoff (hier: MDH) eingesetzt in Kombination mit Synergisten (Nanoclay, Zinkstannat). Die mechanischen, elektrischen und FR-Eigenschaften sind im Vergleich zum aufgeführten Standard herausragend.

*5)*

Rezeptur:

| | |
|---|---|
| EVA | 55% |
| MKRS-HT nanoskalig | 18,5% |
| MDH | 18,5% |
| Nanoclay | 5% |
| Flamtard S | 3% |

Die Nicht-Polymerkomponenten sind mit der Oberflächenmodifizierung "B" versehen.

Ergebnisse:

| | |
|---|---|
| ZF: | 19,6 |
| EL: | 2,9 |
| SDW: | E 15 / E 15 |
| UL 94 V (1,6 mm): | V-0 |
| LOI: | 41 |

Kommentar:

In dieser Rezeptur wird im Vergleich zur Rezeptur 4) eine verringerte Menge Flammschutzmittel (Kombination MKRS-HT nanoskalig mit MDH und Synergisten (Nanoclay und Flamtard S)) mit der Oberflächenmodifizierung nach Rezeptur "B" eingesetzt. Trotzdem werden Ergebnisse erreicht, die mit denen von Rezeptur 4) vergleichbar sind.

<u>Beispiele für PVC:</u>

*0) Basisrezeptur als Nullprobe*

Rezeptur:

| | |
|---|---|
| PVC DS 7060 | 24,7 % |
| Plasticizer DIOP | 12,3 % |
| ATH Superfine SF4 ESD | 61,7 % |
| Irgastab EZ 712 | 1,3 % |

Ergebnisse:

| | |
|---|---|
| Time to Ignite (sec) | 34 |
| PHRR (KW/m2) | 118 |
| THR (MJ/m2) | 50,8 |
| Specific Extinct. Area (m2/kg) | 116,5 |
| Fire Performance Index (m2 s/KW) | 0,3 |
| Smoke Parameter (MW/kg) | 18,7 |

Kommentar:

Diese Rezeptur ist der Vergleichsstandard für PVC-Formulierungen.

*1)*

Rezeptur:

| | |
|---|---|
| PVC DS 7060 | 24,7 % |
| Plasticizer DIOP | 12,3 % |
| MKRS-HT | 61,7 % |
| Irgastab EZ 712 | 1,3 % |

Ergebnisse:

| | |
|---|---|
| Time to Ignite (sec) | 69 |
| PHRR (KW/m2) | 106 |
| THR (MJ/m2) | 23,1 |
| Specific Extinct. Area (m2/kg) | 122,0 |
| Fire Performance Index (m2 s/KW) | 0,7 |

(fortgesetzt)

| Smoke Parameter (MW/kg) | 14 |
| --- | --- |

Kommentar:

In dieser Rezeptur kommt modifizierter karbonisierter RS (MKRS-HT) zum Einsatz. Die Flammschutzwerte sind gegenüber dem ATH-basierenden Standard verbessert.

Beispiele für PP:

*0) Basisrezeptur als Nullprobe*

Rezeptur:

| PP 8400 | 35% |
| --- | --- |
| MDH | 65% |

Ergebnisse:

| ZF: | 24,3 |
| --- | --- |
| RF: | 10,8 |
| EL: | 0,021 |
| E-Mod.: | 3400 |
| a(n): | 5,8 |
| UL 94V (3,2 mm): | V-0 |
| MFI (230 /5) : | 4,6 |

Kommentar:

Diese Rezeptur ist der in der Kunststoffindustrie akzeptierte Vergleichsstandard auf Basis MDH.

*1)*

Rezeptur:

| PP 8400 | 35% |
| --- | --- |
| MKRS-HT | 65% |

Ergebnisse:

| ZF: | 17,5 |
| --- | --- |
| EL: | 0,23 |
| UL 94 V (3,2 mm): | V-2 |
| MFI (230/5): | 1,5 |

Kommentar:

In dieser Formulierung kommt ausschließlich modifizierter karbonisierter Rotschlamm (MKRS-HT) zum Einsatz. Die Reißdehnung ist gegenüber der Nullprobe verbessert, der Flammschutz erreicht die dort angegebenen Werte niveaumäßig noch nicht.

2)

Rezeptur:

| | |
|---|---|
| PP 8400 | 35% |
| MKRS-HT | 60% |
| Nano | 5% |

Die Nicht-Polymerkomponmenten sind mit der Oberflächenmodifizierung "D" versehen.

Ergebnisse:

| | |
|---|---|
| ZF: | 19,1 |
| EL: | 0,56 |
| a(n): | o.Br(67) |
| UL 94 V (3,2 mm): | V-0 |
| MFI (230/5): | 6.1 |

Kommentar:

In dieser Rezeptur kommt neben modifiziertem karbonisiertem Rotschlamm (MKRS-HT) noch Nanoclay als Synergist sowie eine Oberflächenbeschichtung gemäß Rezeptur "D" zum Einsatz. Die mechanischen und die Flammfestigkeitswerte entsprechen dem Standard. Die Verarbeitbarkeit ist stark verbessert.

Beispiele für Polypropylen mit Bromorganischem Flammschutz

*0) Basisrezeptur als Nullprobe*

Rezeptur:

| | |
|---|---|
| PP 8400 | 63% |
| Pentabromdiphenylether | 12% |
| Antimontrioxid | 5% |
| Mica | 20% |

Ergebnisse:

| | |
|---|---|
| ZF: | 23,6 |
| EL: | 0,023 |
| a(n) | 15,5 |
| UL 94 V(1,6 mm): | V-2 |

(fortgesetzt)

| MFI (230/5): | 7 |
|---|---|

Kommentar:

Dies stellt eine polyolefinische FR-Formulierung dar, welche als Vergleichsprobe zu der nachfolgenden Rezeptur dient.

1)

Rezeptur:

| PP 8400 | 63% |
|---|---|
| Pentabromdiphenylether | 6% |
| Antimontrioxid | 2% |
| MKRS-HT | 29 |

Ergebnisse:

| ZF: | 25,8 |
|---|---|
| EL: | 0,17 |
| a(n) | ohne Bruch (o. Br.) |
| UL 94 V (1,6 mm): | V-0 |
| MFI (230/5): | 6 |

Interpretation:

Bei einer Halbierung der Beladung an halogenorganischem/ Antimontrioxid- Flammschutz - System (in Prozent) ergibt der Einsatz des erfindungsgemäßen MKRS-HT an Stelle von Mica (Glimmer) ein Compound, das im Brandtest nach UL 94 Vertikal ein V-0 erreicht. Dazu sind die mechanischen Werte erheblich besser als die der Nullprobe.

Beispiele für Polyamid:

0) Basisrezeptur als Nullprobe

Rezeptur:

| PA B3L | 45% |
|---|---|
| MDH (H-7) | 55% |

Ergebnisse:

| E-Mod.: | 5000 |
|---|---|
| ZF(RF): | 58 (58) |
| EL: | 0,023 |
| a(n) : | 21 |

(fortgesetzt)

UL 94(3,2 mm):     V-0

Kommentar:

Das PA B3L ist ein schlagzäh-modifiziertes Modell für ein weit verbreitetes "Engineering Plastic"-PA, welches u.a. in FR-Anwendungen wie FI-Schutzschaltungen verwendet wird.

Diese Rezeptur gilt in der entsprechenden Kunststoffindustrie als flammgeschützter Polyamid-Vergleichsstandard.

1)

Rezeptur:

| | |
|---|---|
| PA B3L | 45% |
| MKRS-HT | 55% |

Ergebnisse:

| | |
|---|---|
| ZF: | 55 |
| RF: | 55 |
| EL: | 0,018 |
| E-Mod: | 4520 |
| a(n): | 19 |
| UL 94 V (3,2 mm): | V-2 |

Kommentar:

In dieser Rezeptur kommt modifizierter karbonisierter RS (MKRS-HT) zum Einsatz. Die mechanischen Werte entsprechen, der Flammwidrigkeitswert ist schlechter als der Standard.

2)

Rezeptur:

| | |
|---|---|
| PA B3L | 45% |
| MKRS-HT | 55% , versehen mit der Oberflächenmodifizierung A |

Ergebnisse:

| | |
|---|---|
| ZF (RF): | 65 (65) |
| EL: | 0,09 |
| E-Mod: | 5600 |
| a(n): | 32 |
| UL 94 V (3,2 mm): | V-1 ; (1,6 mm): n.e. |

Kommentar:

In dieser Rezeptur kommt neben modifiziertem karbonisiertem RS (MKRS-HT) eine Oberflächenmodifizierung nach der Rezeptur "A" zum Einsatz. Die Oberflächenmodifizierung A verbessert speziell die Flammfestigkeit des Compounds ganz erheblich, obwohl diese noch nicht das Niveau des Standards erreicht, aber schon erheblich besser ist als die in Rezeptur 1).

Daneben verbessern sich auch die mechanischen Eigenschaften beträchtlich, was für technisch anspruchsvolle Anwendungen hilfreich ist.

3)

Rezeptur:

| PA B3L | 45% |
|---|---|
| MKRS-HT | 50% |
| Nanoclay | 5% |

Die Nicht-Polymerkomponenten sind mit der Oberflächenmodifizierung D versehen

Ergebnisse:

| ZF: | 63 | |
|---|---|---|
| RF: | 63 | |
| EL: | 0,29 | |
| E-Mod: | 5500 | |
| a(n): | 34 | |
| UL 94 V(3,2 mm): | V-0 | ;(1,6 mm): V-1 |

Kommentar:

In dieser Rezeptur kommt neben modifiziertem karbonisiertem Rotschlamm (MKRS-HT) der Synergist Nanoclay und die Oberflächenmodifizierung gemäß Rezeptur "D" zum Einsatz.

Diese Compoundformulierung liefert eine hervorragende Flammfestigkeit, was eine Reduzierung der Wandstärke der elektrischen Bauteile erlaubt. Dabei erreichen die mechanischen Werte den Industrie-Standard.

Diskussion

Aus Rotschlamm, der bei der Gewinnung von ATH aus Bauxit nach dem Bayer-Verfahren als Abfallprodukt entsteht, können durch Rehydratisierung und erfindungsgemäß durch Karbonisierung hervorragende anorganische, halogenfreie Flammschutzmittel gewonnen werden. Rotschlamm zeigt auch ohne chemische Behandlung eine gewisse flammhemmende Wirkung, die auf Restgehalte von Gibbsit/Boehmit bzw. Goethit und andere synergistische Effekte im Rotschlamm zurückzuführen ist, aber insgesamt schwach und stark schwankend, also undefiniert sind. Erst durch Rehydratisierung und vor allem durch Karbonisierung von RS entstehen Flammhemmer mit definierten Eigenschaften.

Durch Rehydratisierung wird der Gehalt an Hydroxiden/Oxidhydraten des Aluminiums und Eisens erhöht. Diese Produkte entfalten ihre flammhemmende Wirkung zwischen ca. 220°C und 350°C. Durch Karbonisierung entsteht aus Rotschlamm vor allem Fe(II)carbonat, das seine flammhemmende Wirkung zwischen ca. 350°C und 500°C durch Zersetzung in Eisenoxid und $CO_2$ entwickelt.

Somit können Flammhemmer hergestellt werden, die entweder im Temperaturbereich zwischen 350°C bis 500°C wirken, also Hochtemperaturflammhemmer darstellen oder im Temperaturbereich zwischen 220°C und 350°C wirken, also Niedrigtemperaturbereichflammhemmer darstellen oder durch besondere Reaktionsführung oder durch Mischung sowohl den Niedrigtemperatur- wie auch Hochtemperaturbereich abdecken und damit zwischen 220°C und 500°C aktiv sind.

Zusammen mit den sonst noch im Rotschlamm vorhandenen Substanzen wie Silikate, Aluminiumsilikate, $TiO_2$, etc. die ebenfalls spezifisch oder synergistisch wirken, stehen damit neue, preisgünstige OHFR-Produkte zur Verfügung, die maßgeschneidert für jedes Polymer hergestellt werden können. Die bisher im Markt angebotenen Produkte sind ATH und MDH, die zwischen 180°C bis ca. 350°C wirken. ATH deckt den Bereich von 180°C bis ca. 220°C ab, MDH als sog. "Hochtemperaturflammhemmer" den Bereich bis 350°C. Die aus Rotschlamm durch Rehydratisierung bzw. erfindungsgemäß durch Karbonisierung gewonnenen Produkte decken mit einem einzigen Produkt Temperaturintervalle zwischen 220°C und 350°C, 350°C und 500°C bzw. 220°C und 500°C ab.

Die aus Rotschlamm hergestellten Produkte können sowohl physikalischen als auch chemischen Veränderungen unterworfen werden. Unter physikalischen Veränderungen werden insbesondere die Einstellung der mittleren Korngröße und die Restfeuchte verstanden. Zu den chemischen Veränderungen gehören die Einstellung des Anteils an "$Na_2O$-löslich" (wasserlöslichem Natriumverbindungen) sowie Oberflächenbeschichtungen mit Substanzen wie z. B. Organosilane, Organotitanate, Organozirkonaluminate, Carbonsäuren, Hydroxy-Carbonsäurederivate, Weichmacher, Oligomere, Polymer-Precursors, Polymere, Ionomere, Borsäure und deren Metallsalzderivate, Zinkstannate, Zinkhydroxystannate oder Kombinationen hiervon. Weiterhin können diese Produkte mit Synergisten wie z. B. Organoclays (Nanoclays), Zinnverbindungen, Borsäure, Fluorpolymere (kleiner 5 %) etc. kombiniert sein.

In den Beispielen sind Tests mit folgenden Polymeren durchgeführt worden: EVA, PP, Polyamid 6 und PVC. Getestet wurde gegenüber ATH, MDH und Pentabromphenylether/Antimontrioxid als Nullproben. Als erfindungsgemäße Produkte kamen MKRS-HT oder MR2S-NT/MKRS-H zum Einsatz.

Folgende Ergebnisse konnten erzielt werden:

EVA

Die in den Beispielen genannten Formulierungen ergaben Compounds, die sehr gute mechanische Werte, hervorragende Werte für den spezifischen Durchgangswiderstand und im Flammschutz vergleichbare Werte zu mit ATH ausgerüsteten Compounds ergaben. Die Compounds können in allen W & C Anwendungen eingesetzt werden.

PVC

Die in Beispiel 1) aufgeführte Rezeptur ist in ihren Flammschutzwerten gegenüber dem ATHbasierenden Standard verbessert.

PP

Die in Beispiel 2) aufgeführte Rezeptur entspricht in den mechanischen Werten und den Flammschutzwerten dem Standard.

Bei mit bromorganischem Flammschutz ausgerüstetem PP wurde in Rezeptur 1) gegenüber der Nullprobe die Menge an Pentabromdiphenylether/Antimonoxid halbiert und Mica (Glimmer) weggelassen. Dafür wurde MKRS-HT eingebaut. Diese Rezeptur zeigte bessere mechanische Eigenschaften und erreicht den Brandschutz UL 94 vertikal (VO).

PA

Die in Beispiel 3) aufgeführte Formulierung erreicht in den mechanischen Werten den Standard. Die Flammfestigkeit ist hervorragend.

Insgesamt ist somit festzustellen, dass modifizierter, karbonisierter Rotschlamm (MKRS-HT) oder modifizierter, rehydratisierter Rotschlamm (MR2S-NT) oder Mischungen aus beiden z. B. durch spezielle Prozessführung oder durch Mischen von MR2S-NT und MKRS-HT OHFR-Systeme ergibt, die in einem Produkt der bisher durch ATH und MDH abgedeckten Technologie entspricht. Erfindungsgemäß kommt nunmehr mit MKRS-HT ein zusätzliches Produkt in den Markt, das für den Hochtemperaturbereich (350°C - 500°C) bestens geeignet ist. Zusätzlich scheint die Rotschlamm -Matrix in die die durch Modifizierung hergestellten Produkte MR2S-NT und/oder MKRS-HT eingebettet sind, die Reaktionsintervalle, in denen Hydroxide/Oxidhydrate des Aluminiums und Eisens wirken, in höhere Temperaturbereiche zu verschieben.

Die Oberflächenmodifizierung der Siderit-optimierten MKRS-HT-Variante ergibt exzellentes Verhalten in der Wasserlagerung, d.h. es ist praktisch kein Abfall im Spezifischen Durchgangswiderstand zu beobachten. Dies ist für ein mineralisches Flammschutzmittel ein außergewöhnliches Ergebnis.

Generell ist festzustellen, dass mit modifiziertem, karbonisiertem und/oder rehydratisiertem Rotschlamm, d.h. mit MKRS-HT oder MR2S-NT oder MKRS-HT/MR2S-NT für jeder Polymer maßgeschneiderte OHFR-Systeme gefunden werden können, die gegenüber bisher eingesetzten Produkten deutlich wirtschaftlicher sind, dabei aber vergleichbare Ergebnisse hinsichtlich mechanischer Werte und vor allem im Flammschutz erreichen. Diese OHFR-Systeme können auch mit denen im Markt befindlichen Produkten zur Erzielung oder Verdeutlichung spezieller Effekte gemischt werden, z. B. mit ATH, MDH, Brucit oder Huntit etc.

SCHWERSPAT-ERSATZ

Erfindungsgemäß ist weiterhin festzustellen, dass Rotschlamm, modifizierter, rehydratisierter und karbonisierter Rotschlamm und Mischungen daraus in bestimmten Anwendungen Schwerspat ersetzten kann. Derartig ausgerüstete Produkte zeigen dann neben der "Schwerspat vergleichbaren Wirkung" zusätzlich eine flammhemmende Wirkung. Es liegt also eine Zweifachwirkung vor. Beispiele für solche Anwendungen sind z. B. Stoßstangen.

SCHALLDÄMMUNG

Erfindungsgemäß ist weiterhin festzustellen, dass Rotschlamm, modifizierter, rehydratisierter und karbonisierter Rotschlamm und Mischungen daraus eine schalldämmende Wirkung haben. Produkte, die damit ausgerüstet sind, zeigen also neben der flammhemmenden auch eine schalldämmende Wirkung. Auch hier liegt also eine Zweifachwirkung vor. Beispiele für solche Anwendungen sind insbesondere Kunststoffsysteme, die im Baubereich Anwendung finden.
Rotschlamm, modifizierter, rehydratisierter und karbonisierter Rotschlamm und Mischungen daraus können auch zum Zwecke der Schalldämmung mineralischen Stoffsystemen zugemischt werden. Beispiele sind hier Gipskartonplatten, Estriche, Beton, etc. Wichtige Anwendungen liegen insbesondere im Baubereich.
Bei den vorherigen und folgenden Ausführungen ist der Gebrauch des Ausdrucks "kann" bzw. "kann sein" synonym zu "vorzugsweise" bzw. "hat vorzugsweise" zu verstehen und soll weitere erfindungsgemäße Ausführungsformen erläutern.
Erfindungsgemäße Ausführungsformen können eines oder mehrere der vorgenannten und/oder folgenden Merkmale aufweisen.

ANTIMONTRIOXID-ERSATZ, WÄRMEDÄMMUNG, WÄRMESPEICHERUNG, ABSCHIRMUNG ELEKTROMAGNETISCHER WELLEN

Manche oder alle erfindungsgemäßen Ausführungsformen können einen, mehrere oder alle der oben und/oder im Folgenden genannten Vorteile aufweisen.
Die bevorzugten vorteilhaften Anwendungsgebiete des erfindungsgemäßen Flammschutzmittels (MKRS-HT und/oder MR2S-NT sind neben dem schon vorher beschriebenen halogenfreien Flammschutzeffekt:

- die teilweise oder, bevorzugt vollständige, Substitution des Antimontrioxids sowohl in PVC-Formulierungen als auch in halogenorganischen flammgeschützten Formulierungen;
- die Wärmedämmung: Insbesondere dort, wo neben der Wärmedämmung in ihren vielfältigen Ausgestaltungsmöglichkeiten auch der Flammschutz des jeweiligen Bauteils eine Rolle spielt;
- die Wärmespeicherung: Insbesondere dort, wo neben der Wärmespeicherung in all ihren technischen Ausgestaltungsmöglichkeiten die Wärmedämmung und der Flammschutz der entsprechenden Bauteile eine Rolle spielt;
- der Schallschutz: Insbesondere dort, wo neben dem Schallschutz auch Eigenschaften wie Wärmespeicherung und/oder Wärmedämmung und insbesondere ein erweiterter und/oder fundamentaler Flammschutz eine Rolle spielen; und/oder
- die Abschirmung elektromagnetischer Strahlung : Insbesondere dort, wo neben einem Flammschutz-Effekt auch Wärmespeicherung und/oder Wärmedämmung und/oder elektromagnetische Strahlung, resultierend beispielsweise aus diversen Quellen mit unterschiedlicher Energie und zum Teil desaströsen Auswirkungen auf die Integrität elektrischer und/oder elektronischer Bauteile und/oder ganzer Systeme, sowie die Einflüsse von sogenannten. "Elektro-Smog" auf Bewohner und/oder sensible Menschen, minimiert werden soll.

Diese Anwendungsgebiete sind insbesondere dort wesentlich, wo es z.B. im Bau- oder Anlagenbaubereich neben den beschriebenen Effekten auch um einen effizienten halogenfreien Flammschutz geht.
Hierbei können prinzipiell die genannten typischen Effekte nach Belieben und technischer Notwendigkeit miteinander kombiniert werden, um das gewünschte Eigenschaftsprofil zu erreichen.
Wie bereits eingeführt gibt es, generell betrachtet, drei Hauptansätze, um einen gewissen Flammschutz in Polymersystemen zu erreichen:

- Intumeszierende FR-Systeme (Beispielsweise Melamin-Derivate + Polymer; etc);
- Halogenfreie FR-Systeme (insbesondere: ATH, MDH, APP, etc); und/oder

- Halogenenthaltende FR-Systeme (Beispielsweise PVC + Antimontrioxid;

Halogenorganische FR + Sb2O3 + Polymer; etc).

Für die halogenenthaltenden FR-Systeme ist das erfindungsgemäße Flammschutzmittel (MKRS-HT und/oder MR2S-NT, ebenso wie vorgehend für die halogenfreien FR-Systeme beschrieben, optimal geeignet.

Die vorliegende Erfindung betrifft daher ferner die Verwendung eines erfindungsgemäßen Flammschutzmittels oder die Verwendung von Mischungen eines erfindungsgemäßen Flammschutzmittels mit Rotschlamm als Füllstoff, insbesondere in Kunstoffssysteme, bevorzugt anstelle von Schwerspat. Damit kann es vorteilhaft möglich sein, compoundierten Kunststoffen gleichzeitig eine flammhemmende Ausrüstung zu verleihen.

Weiterhin betrifft die Erfindung die Verwendung des erfindungsgemäßen Flammschutzmittels als Substitut bzw. Ersatzmittel für Antimontrioxid (Sb2O3).

In vorteilhaften erfindungsgemäßen Ausführungsformen kann das erfindungsgemäße Flammschutzmittel alternativ zumindest teilweise oder vollständig als Substitut bzw. Ersatzmittel für Antimontrioxid (Sb2O3) eingesetzt werden.

Insbesondere in PVC-Wire & Cable Compounds, wie auch in halogenorganisch flammgeschützten Compounds (Hal-FR-Compounds), wird als Synergist üblicherweise Antimontrioxid eingesetzt.

Im PVC -Compound reagiert im Brandfall das Antimontrioxid mit dem in der Pyrolyse freigesetzten Halogen-Intermediate zu Antimonoxychlorid (SbOCl) oder Antimonoxybromid (SbOBr), welche beide als Radikalfänger in der Gasphase wirksam sind und so den Brandvorgang unterbrechen.

Hierbei sind die vorgenannten wirksamen Verbindungen größtenteils für die hohe Rauchgasdichte verantwortlich. Da die Rauchgasdichte im Brandfall dazu führt, dass betroffene Personen die Fluchtwege nicht erfolgreich nutzen können und so zu Schaden kommen können, ist es vorteilhaft wenn die Rauchgasdichte minimiert wird. Dabei darf jedoch speziell die Brandhemmung im Gesamtsystem nicht beeinträchtigt werden.

Das für gewöhnlich eingesetzte Antimontrioxid hat allerdings mehrere Nachteile. Das sind neben den vorgenannten Punkten sowohl die Toxizität, die auf krebserregenden, teratogenen und/oder mutagenen Effekten basiert, auch der Preis, der für eine angespannte Versorgungssituation sorgt.

Die als mögliche Substitute geeigneten Verbindungen wie Zinkmolybdat, Kalziummolybdat oder Antimonpentoxid haben andere Nachteile. Beispielsweise haben sie einen noch höheren Preis verglichen mit Antimontrioxid. Außerdem generieren sie in vielen Compound-Formulierungen erhebliche Stabilitätsprobleme.

Hier bietet der Einsatz des erfindungsgemäßen Flammschutzmittels (MKRS-HT und/oder MR2S-NT); an Stelle des Antimontrioxids eine vorteilhafte Alternative. Insbesondere ist die erfindungsgemäße Verwendung des erfindungsgemäßen Flammschutzmittels technisch ebenso wirksam und vor allem nicht toxisch. Außerdem ist die erfindungsgemäße Verwendung des erfindungsgemäßen Flammschutzmittels auch aus Marktgesichtspunkten, insbesondere betreffend die Verfügbarkeit und/oder den Preis, vorteilhaft.

Da das erfindungsgemäße Flammschutzmittel (MKRS-HT und/oder MR2S-NT, ein mit dem kommerziell verfügbaren Antimontrioxid vergleichbares Kornverteilungsspektrum aufweist, kann es vorteilhaft, ebenso wie dieses, präpariert werden. Insbesondere kann das erfindungsgemäße Flammschutzmittel als Masterbatch, als Pulver beziehungsweise als Paste in das Compound vorteilhaft eingearbeitet werden. Dadurch kann es vorteilhaft möglich sein, kostenträchtige Zusatzschritte in der Compoundierung zu vermeiden.

Weiterhin betrifft die Erfindung die Verwendung des erfindungsgemäßen Flammschutzmittels als Synergist.

In vorteilhaften erfindungsgemäßen Ausführungsformen kann der Synergist insbesondere in der Lage sein, bei einem Brand entstehende halogenhaltige Zwischenprodukte abzufangen bzw. zu binden.

Weiterhin betrifft die Erfindung die Verwendung des erfindungsgemäßen Flammschutzmittels als thermischer Stabilisator. Damit kann es vorteilhaft möglich sein, die Thermostabilität von Stoffsystemen, welche das erfindungsgemäße Flammschutzmittel enthalten, gezielt zu erhöhen bzw. generell zu steuern.

In vorteilhaften erfindungsgemäßen Ausführungsformen kann das erfindungsgemäße Flammschutzmittel insbesondere in Polyvinylchlorid (PVC)-haltigen Zusammensetzungen bzw. bei PVC-haltigen Compounds und/oder halogenhaltigen flammgeschützten Zusammensetzungen insbesondere als thermischer Stabilisator vorgesehen und/oder geeignet sein.

In weiteren vorteilhaften erfindungsgemäßen Ausführungsformen kann das erfindungsgemäße Flammschutzmittel insbesondere in Polyvinylchlorid (PVC)-haltigen Zusammensetzungen bzw. PVC-haltigen Compounds und/oder halogenhaltigen flammgeschützten Zusammensetzungen insbesondere als Füllstoff und/oder als Substitut bzw. Ersatzmittel für Antimontrioxid (Sb2O3) und/oder als Synergist und/oder als thermischer Stabilisator eingesetzt werden.

In anderen vorteilhaften erfindungsgemäßen Ausführungsformen kann es sich bei den PVC-haltigen Zusammensetzungen insbesondere um PVC-haltige Kabel bzw. PVC-haltige Kabelcompounds handeln.

In bestimmten vorteilhaften erfindungsgemäßen Ausführungsformen können die PVC-haltigen Zusammensetzungen ferner zusätzlich einen Weichmacher enthalten.

BEISPIELE:

Die jeweiligen Compounds werden mittels eines Buss-Ko-Kneters (MDK/ E 46 -11 D / GS 46 (3,5 D)) hergestellt und die entsprechenden Granulate zu Testkörpern mittels eines Laborwalzwerks und einer beheiz- bzw. kühlbaren Doppelplatten-Presse- verarbeitet.

Vor dem jeweiligen Test werden die Prüfkörper im Norm-Klima (23°C, 50% relative Raumfeuchte) für 48 Stunden equilibriert. Tabelle 5 und 6 geben einige Ergebnisse wieder.

**Tabelle 5**

| Rauschgasdichte | | | |
|---|---|---|---|
| Rauchgasunterdrücker | Kontroll-Compound | $Sb_2O_3$ | MKRS-HT |
| NBS-Smoke Chamber (ASTM E 662) Flaming Mode | | | |
| D 90 (average) | 56 | 31 | 20 |
| D 4.0 (average) | 224 | 144 | 110 |
| D max. (average) | 350 | 260 | 208 |
| Limiting Oxygen Index | 40 | 42 | 46 |

Rezeptur : PVC Oxyvinyl-240 (100 phr), Blei-Fumarat- 9 phr,TOTM-35 phr, Cl.-PE -15 phr, Epox.Sojabohnen-Öl -3 phr, Sb2O3 -2 phr, MgO -10 phr, SF4 ESD (ATH) 29-phr, Kreide (Ultracarb U5) -29 phr, jeweiliger Rauchgasunterdrücker -10 phr

**Tabelle 6)**

| Dynamische Stabilität in "Lead-free" PVC-Formulierung | | |
|---|---|---|
| Formulierungsbestandteil In phr | Kontroll-Compound | Comp. Enthaltend MKRS-hat |
| Oxyvinyl 240 (PVC) | 100 | 100 |
| SF4 ESD(ATH) | 80 | 40 |
| Uniplex FRP-45 | 20 | 20 |
| Sanctiziser 2148 | 32 | 32 |
| Stearinsäure | 1 | 1 |
| Bäropan MC 91108 KA | 8 | 8 |
| MKRS-Hat | | 40 |
| Dekomposition Zeit | 38 :10 | 47:54 |

Weiterhin betrifft die Erfindung die Verwendung des erfindungsgemäßen Flammschutzmittels zur Wärmespeicherung bzw. als wärmespeicherndes Material.

Die Wärmespeicherfähigkeit eines Baukonstruktionsmaterials wird generell durch die Wärmespeicherzahl S beschrieben, die zur spezifischen Wärme C und zur Rohdichte ρ proportional ist:

$$S = C * \rho \quad (kJ/m^3.K) \text{ oder } (Wh/m^3K).$$

Diese gibt die Wärmemenge an, die erforderlich ist um 1 m$^3$ des Baumaterials um 1 Kelvin (= 1°C) zu erwärmen.

Die Wärmespeicherfähigkeit Q ist determiniert durch die Bauteil-Dicke s und die Wärmespeicherzahl S:

$$Q = C \rho s \quad (kJ/m^2K) \text{ oder } (Wh/m^2K).$$

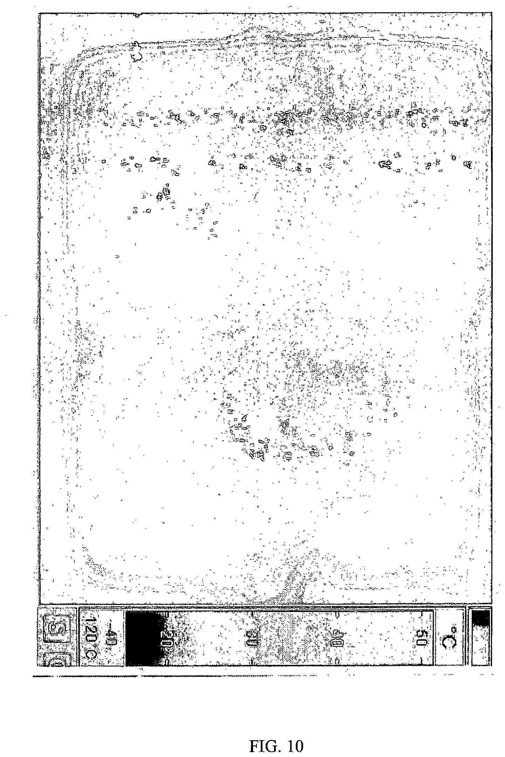

Vergleichsuntersuchungen zwischen handelsüblichen Gipskartonplatten und mit dem erfindungsgemäßen Flammschutzmittel (MKRS-HT und/oder MR2S-NT; hergestellten hochgefüllten Platten, die auf einer Polymermatrix basieren, zeigten überraschenderweise, dass sich die mit dem erfindungsgemäßen Flammschutzmittel (MKRS-HT und/oder MR2S-NT;) hergestellten Platten in der massiven Ausführung bei gleicher Starttemperatur sehr viel langsamer abkühlten als die kommerziellen Gipskartonplatten. Figur 10 zeigt beispielhaft ein Thermo-Kamera-Bild einer solchen Platte während ihrer Abkühlung.

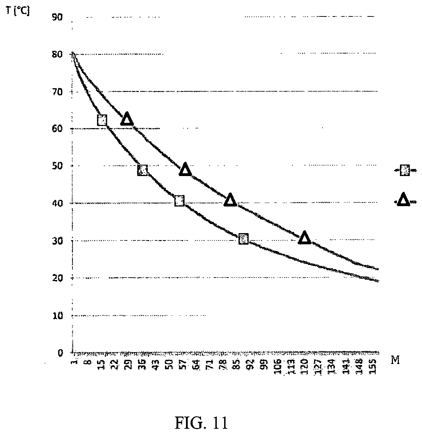

Figur 11 zeigt beispielhaft die jeweiligen Abkühlungskurven zweier vermessener TestPlatten. Eine Test-Platte ist eine Gipsplatte mit einer Schichtdicke von 10mm (siehe die Kurve mit den quadratischen Symbolen). Die andere Test-Platte ist eine mit dem erfindungsgemäßen Flammschutzmittel (MKRS-HT und/oder MR2S-NT hergestellte Test-Platte, welche Gips und 30 Gew.% eines erfindungsgemäßen Flammschutzmittels mit einer Schichtdicke von 10mm aufweist (siehe Kurve mit den dreieckigen Symbolen). Beide Platten wurden dabei 3h in einem Trockenschrank bei 80°C gelagert. Anschließend wurden sie vertikal arretiert und ihre Wärmeabstrahlung mit Hilfe einer Wärmebildkamera gemessen und aufgezeichnet. Dabei wurden 5 Kamerabilder pro Minute während 31 Minuten aufgenommen. Die horizontale Achse weist daher 155 Messpunkte M auf. Wie in Figur 11 deutlich zu erkennen, kühlen die mit dem erfindungsgemäßen Flammschutzmittel (MKRS-HT und/oder MR2S-NT hergestellten Platten langsamer als die kommerziellen Gipsplatten ab. Ähnliches wird zwischen kommerziellen und mit dem erfindungsgemäßen Flammschutzmittel (MKRS-HT und/oder MR2S-NT; hergestellten Gipskartonplatten, auch mit anderen Gewichtsprozenten des erfindungsgemäßen Flammschutzmittels, beobachtet.

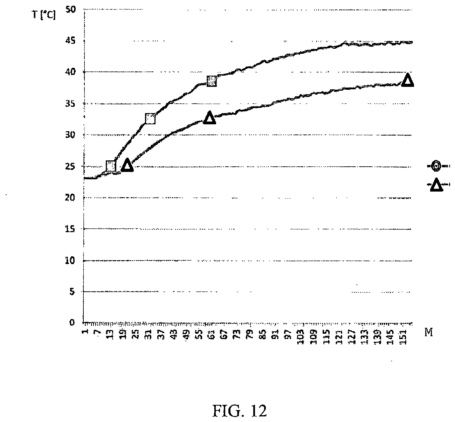

Figur 12 zeigt beispielhaft die jeweiligen Erwärmungskurven zweier vermessener TestPlatten. Eine Test-Platte ist eine kommerzielle Gipsplatte (siehe die Kurve mit den Flammschutzmittel (MKRS-HT und/oder MR2S-NT hergestellte Test-Platte (siehe Kurve mit den dreieckigen Symbolen), die beim Abbinden Mikroporen ausgebildet hat. Für die Untersuchung der Wärmeisolationseigenschaften wurden dabei zwei Testplatten vertikal arretiert und ihre jeweilige Rückseite mit einer Heißluftpistole angeblasen. Die Temperatur an der Rückseite betrug danach in beiden Fällen jeweils 95°C. Die Temperatur wurde mit Hilfe einer Wärmebildkamera an der Vorderseite der jeweiligen Platten aufgezeichnet und ermittelt. Dabei wurde ein Messintervall von 5 Bildern pro Minute eingestellt. Die horizontale Achse weist hier 151 Messpunkte M auf. Es wird deutlich, dass die mit dem erfindungsgemäßen Flammschutzmittel (MKRS-HT und/oder MR2S-NT) hergestellte Test-Platte gegenüber der kommerziellen Gipsplatte eine stärkere Wärmeisolation aufweist.

Durch die erfindungsgemäße Substanz besteht erstmals die vorteilhafte technische Möglichkeit dieses Wärmespeichervermögen in einer Polymermatrix, unter gleichzeitiger Garantie für halogenfreien Flammschutz im Gesamtsystem, zu nutzen. Dies bietet speziell im Bereich der Composite-Herstellung erhebliche Vorteile.

Sobald dieses System in einer Polymermatrix zwecks leichterer Produktion inkorporiert wird, ist, um die Integrität des Gesamt-Composites zu gewährleisten, Flammschutz von Nöten. Dies kann vorteilhaft und erfindungsgemäß mittels einem erfindungsgemäßen Flammschutzmittel (MKRS-HT und/oder MR2S-NT erreicht werden.

Hierbei ermöglicht die Verwendung von Polymermatrizen vorteilhaft eine energetisch günstige Herstellung der wärmespeichernden Composite-Systeme, insbesondere in kontinuierlichen Verarbeitungsprozessen (beispielsweise bei Extrusion mit oder ohne Verschäumen).

Weiterhin betrifft die Erfindung die Verwendung des erfindungsgemäßen Flammschutzmittels zur Wärmedämmung bzw. zur Wärmeisolation bzw. als wärmedämmendes bzw. wärmeisolierendes Material.

Die Wärmeleitung eines Stoffes wird durch die Wärmeleitzahl $\lambda$ (W/mK) bestimmt. Diese Zahl gibt an, wie viel Wärme, gemessen in $W/m^2$, durch eine Wand von 1 Meter Dicke bei einer Temperaturdifferenz von 1 Kelvin (= 1°C) geht.

Generell geht die Rohdichte eines Wandmaterials in die Wärmeleitzahl insofern ein, als dass mit steigender Rohdichte (= kompakteres Material) die Wärmeleitzahl zunimmt. Dies bedeutet im Umkehrschluss, dass ein möglichst leichtes Material, vorzugsweise ein vakuumisiertes System oder ein nanozelliges, geschäumtes Material, in dessen Poren die Freie Weglänge des darin enthaltenen Gases minimal ist, die geringste Wärmeleitzahl und damit das beste Wärmeisolationsverhalten aufweist.

Bei organischen Bauteilmaterialien sowie natürlichen Baustoffen, die Feuchtigkeit aufnehmen oder abgeben können, spielt der Feuchtigkeitsgehalt insofern eine Rolle, als bei steigender Feuchtigkeit im Baumaterial die Wärmedämmwirkung abnimmt.

Weiterhin betrifft die Erfindung die Verwendung des erfindungsgemäßen Flammschutzmittels zur Schalldämmung bzw. als Schallschutz bzw. als schalldämmendes Material.

Um den Körperschall, der die Schallübertragung von einem Bauteilsytem zu einem anderen bedeutet, zu verringen und/oder zu verhindern, müssen zum Teil umfangreiche konstruktive Maßnahmen ergriffen werden. Solche Maßnahmen bedingen in der Regel ein Aufeinanderabstimmen des Gesamtsystems. Eine überaus wichtige Maßnahme in diesem Zusammenhang ist beispielsweise die Trittschalldämmung. Diese wird in der Regel konstruktiv so gelöst, dass die Übertragung der Trittschallschwingungen vom Fußboden auf die eigentliche Deckenkonstruktion durch Entkopplung verringert wird. Dazu werden zwischen Fußboden und Decke stark dämpfende Materialien dazwischengeschaltet, die eine hohe innere Dämpfung haben, wie z.B. Kork, Gummi, Schwingmetall oder Steinwolle.

Die Luftschalldämmung lässt sich, generell gesagt, durch Bauteile bzw. Systeme mit hohem spezifischem Gewicht realisieren.

In manchen vorteilhaften erfindungsgemäßen Ausführungsformen der vorliegenden Erfindung kann das erfindungsgemäße Flammschutzmittel in einem Baumaterial und/oder in einem Anlagenbaumaterialien vorliegen.

In anderen vorteilhaften erfindungsgemäßen Ausführungsformen der vorliegenden Erfindung kann das erfindungsgemäße Flammschutzmittel in einer Matrix vorliegen.

In weiteren vorteilhaften erfindungsgemäßen Ausführungsformen kann die Matrix insbesondere eine thermoplastische oder eine duromere Matrix, insbesondere einer Polymermatrix, sein.

In bestimmten vorteilhaften erfindungsgemäßen Ausführungsformen kann das erfindungsgemäße Flammschutzmittel in einem Composit vorliegen.

In manchen vorteilhaften erfindungsgemäßen Ausführungsformen kann das Composit eine Matrix und, optional, Hilfsstoffe und/oder Additive enthalten.

In weiteren vorteilhaften erfindungsgemäßen Ausführungsformen kann das Composit massiv und/oder geschäumt sein. Insbesondere kann ein solches Composit einen geschäumten Kern und/oder eine geschlossene Oberfläche aufweisen.

In manchen vorteilhaften erfindungsgemäßen Ausführungsformen kann das Composit insbesondere ein spezifisches Gewicht von 15 bis 800 kg/m$^3$ aufweisen.

In noch weiteren vorteilhaften erfindungsgemäßen Ausführungsformen kann das erfindungsgemäße Flammschutzmittel in einem Schaum vorliegen.

In anderen vorteilhaften erfindungsgemäßen Ausführungsformen der vorliegenden Erfindung kann der Schaum ein thermoplastisches und/oder ein mit einem thermoplastischen Elastomer (TPE) modifiziertes vernetztes Material aufweisen.

Insbesondere ist interessant, dass das die erfindungsgemäße Verbindung enthaltende Material sehr schnell aufgeheizt werden kann und seine Energie über einen wesentlichen längeren Zeitraum abgibt. Zusätzlich ist sehr bemerkenswert, dass das erfindungsgemäße Material eine sehr vorteilhafte, weil feinverteilte und gleichmäßige Porenstruktur aufweist. Die Ursache dafür ist der hohe Anteil an nanoskaliger erfindungsgemäßer Verbindung , welcher als starkes Nukleierungsmittel wirkt. Durch geeignete Prozessführung lässt sich die Porenstruktur noch erheblich verbessern.,

In bestimmten vorteilhaften erfindungsgemäßen Ausführungsformen kann der Schaum insbesondere ein Material, ausgewählt aus der Gruppe, bestehend aus Polyethylen (PE), Polypropylen (PP), Polystyrol, insbesondere wie extrudierter Polystyrolhartschaum (X-PS), thermoplastischem Elastomer (TPE) und/oder Mischungen davon, aufweisen.

In manchen vorteilhaften erfindungsgemäßen Ausführungsformen kann das erfindungsgemäße Flammschutzmittel in einem ein Polyurethan enthaltenden oder daraus bestehenden Schaum vorliegen.

In weiteren vorteilhaften erfindungsgemäßen Ausführungsformen kann der Schaum geschlossenzellig und/oder offenzellig sein.

In bestimmten vorteilhaften erfindungsgemäßen Ausführungsformen kann der Schaum insbesondere ein spezifisches Gewicht von 15 bis 800 kg/m$^3$ aufweisen.

Die weiter oben diskutierten flammhemmenden bzw. flammschützenden Eigenschaften des erfindungsgemäßen Flammschutzmittels, können vorteilhaft mit den wärmespeichernden, wärmedämmenden, wärmeisolierenden und/oder schalldämmenden und/oder schallschützenden Eigenschaften des erfindungsgemäßen Flammschutzmittels gezielt und in kontrollierter Weise kombiniert werden, um positive Mehreffekte zu erzielen.

Zurzeit sind hauptsächlich Isolierungsmaterialien (für Anwendung am Bau sowohl im Innenausbau als auch im Außenbau) am Markt, die technisch betrachtet einen unzureichenden oder gar keinen Flammschutz besitzen oder die, falls flammwidrig, mit den problematischen Organohalogen-Flammschutzmitteln und/oder dem Synergisten Antimontrioxid ausgerüstet sind, der ebenfalls als toxisch, karzinogen und/oder mutagen registriert ist und unter strenger Beobachtung der Regulierer steht.

Die Ausrüstung mit dem umweltfreundlichen halogenfreien Flammschutzmittel Magnesiumhydroxid z.B., hat den Nachteil eines hohen Beladungsgrades, welcher nötig ist, um einen substanziellen Flammschutz, beispielsweise nach DIN /ISO 4102-B (Teil 1 oder 2) zu erhalten. Ferner ist eine solche Ausrüstung kostenintensiv.

Dazu macht die Formulierung der Compound-Rezeptur durch die Kornverteilung des MDH Probleme: Ideal ist in Isolier-Schäumen eine Porengröße, die möglichst klein ist, um die Beweglichkeit der eingeschlossenen Gase möglichst gering zu halten. Dies hat das Ziel, die Isolationswirkung zu maximieren. Um möglichst kleine Poren zu erhalten, ist ein Nukleierungsmittel erforderlich, das selbst möglichst fein, vorzugsweise im nanoskaligen Bereich, vorliegt.

Das erfindungsgemäße Material hat einen sehr hohen Korn-Anteil im Bereich von 600 nm, mit einem zweiten Peak in der Kornverteilungskurve im Bereich von 1,2 Mikrometer. Dies bewirkt vorteilhaft beim Schäumprozess mit dem erfindungsgemäßen Flammschutz, dass entsprechend viele nanoskalige Poren entstehen.

Nanoskaliges MDH ist momentan in der Entwicklungsphase und entsprechend teurer als konventionelles MDH. Dadurch ist ein Einsatz in Massensystemen, wegen dem hohen Preis, aktuell nicht vorteilhaft.. Dazu kommt, dass nanoskaliges MDH auf Grund seines Herstellungsprozesses eine sehr geringe Schüttdichte und eine sehr hohe Oberflächenenergie aufweist. Dies führt zu Problemen bei der Compoundierung ("wetting-out") und bei der Ausformung, insbesondere von Bauteilen.

Das erfindungsgemäße Flammschutzmittel (MKRS-HT und/oder MR2S-NT; weist dagegen ein hohes Schüttgewicht und eine geringe Oberflächenenergie auf. Damit können vorteilhaft die mit MDH auftretenden Probleme bei der Compoundierung und/oder bei der Ausformung, insbesondere bei der beispielsweise Extrudierung von insbesondere Bauteilen, vermieden und/oder verhindert werden. Weiterhin kann vorteilhaft die Oberflächenenergie des erfindungsgemäßen Flammschutzmittels durch die weiter oben beschriebene Oberflächenmodifizierung weiter verbessert und/oder positiv beeinflusst werden.

Selbst nicht modifiziert lässt sich das erfindungsgemäße Flammschutzmittel (MKRS-HT und/oder MR2S-NT im Vergleich zum nanoskaligen MDH bspw. sehr leicht und mit hoher Durchsatzleistung, d.h. sehr kosteneffektiv, in eine Polymermatrix einarbeiten.

In Verbindung mit dem günstigen Preis für das erfindungsgemäße Flammschutzmittel (MKRS-HT und/oder MR2S-NT lassen sich dadurch einerseits technische Vorzüge, anderseits Verarbeitungsfreundliche Anwendungsbereiche erschließen, bei denen der Preis konventioneller halogenfreien Flammschutzmittel, wie beispielsweise MDH, insbesondere nanoskaliges MDH, prohibitiv sind.

Allein das erfindungsgemäße Flammschutzmittel (MKRS-HT und/oder MR2S-NT; erlaubt Composites herzustellen, welche halogenfrei flammgeschützt sind und dazu noch Isolationswirkung und/oder thermische Speicherwirkung und/oder Schallschutzwirkung und/oder Abschirmungswirkung elektromagnetischer Felder besitzen.

BEISPIELE

Herstellung der Probekörper:

Im Folgenden ist der Grundprozess der Prüfkörperherstellung (Granulatdarstellung) für die vorteilhaften Verwendungen des erfindungsgemäßen Flammschutzmittels für Wärmedämmung, Wärmeisolation, Schalldämmung, Schallisolation und/oder Wärmespeicherung und/oder elektromagnetische Abschirmung identisch.

Mittels einer Compoundiermaschine (BUSS-Ko-Kneter MDK 46 -11 D/ GS 46 mit zwei ELT (Einlauftrichtern) und Dreifachentgasung) wird das erfindungsgemäße Flammschutzmittel (MKRS-HT und/oder MR2S-NT) und ein Polymer (EVA; Escorene Ultra UL 00119 von ExxonMobil) bei einer Temperatur von 135°C homogen gemischt und anschließend granuliert. Die Granulate werden auf Homogenität und Lufteinschlüsse getestet.

Die Granulate werden anschließend auf einer beheizten und kühlbaren Doppelplatten-Presse in hochglanzpolierten Matrizen zu Platten von den Maßen 200 x 200 x 3,2 und 200x200 x 1,6 mm verpresst und diese Pressplatten unter Druck in der Matrize abgekühlt.

Die resultierenden Platten werden 2 Tage im Normklima (23°C, 50% relative Raumfeuchte) equilibriert und anschließend getestet.

Der Brandtest wird an aus den Platten geschnittenen Probekörpern von 150 mm x 12,7 mm x Probedicke nach UL 94 vertikal vorgenommen.

Als Vergleich dienen Probekörper, bestehend aus dem Polymer und 55 Gew.% und 65 Gew.% Magnesiumhydroxid (Magnifin H 5; von Veitscher Magnesitwerke, Österreich).

Die Vergleichsprobekörper und die Prüfkörper mit 55 Gew. % und 65 Gew. % des erfindungsgemäßen Flammschutzmittels (MKRS-HT und/oder MR2S-NT) ergeben bei 3,2 mm Prüfkörperdicke eine Einstufung nach UL 94 V-0.

Hiermit ist die exzellente Flammfestigkeit des, mit dem erfindungsgemäßen Flammschutzmittel (MKRS-HT und/oder MR2S-NT) hergestellten Compounds erwiesen.

Weiterhin betrifft die Erfindung die Verwendung des erfindungsgemäßen Flammschutzmittels zur Abschwächung bzw. Abschirmung von elektromagnetischer Strahlung.

Mit Strahlung wird die freie Ausbreitung von Energie im Raum verstanden. Dabei unterscheidet man zwischen Teilchen- und elektromagnetische Strahlung. Erstere besteht aus geladenen oder ungeladenen Teilchen, die eine Masse besitzen und sich langsamer als Licht ausbreiten. Letztere, auch Photonenstrahlung, genannt besteht aus einem sich periodisch verändernden elektrischen und magnetischen Feld. Zu ihr zählen neben das sichtbare Licht, ultraviolette Strahlen und die Wärmestrahlung auch die Röntgen-, die Höhen und die Gammastrahlung. Elektromagnetische Strahlung wird durch Wellenlänge, Frequenz und Amplitude gekennzeichnet und ihre Ausbreitungsgeschwindigkeit beträgt im Vakuum ca. die Lichtgeschwindigkeit.

Tritt Photonenstrahlung auf Materie wird sie durch Absorption oder Streuung geschwächt. Die eine exponentielle Gesetzmäßigkeit folgende Schwächung der Strahlung ermöglicht eine theoretisch unendliche Reichweite der Strahlung. Das Maß der Schwächung ist generell von der Körperdichte, der Ordnungszahl der getroffenen Atome und der durchdrungenen Materialschichtdicke abhängig.

In diesem Zusammenhang wurde erfindungsgemäß festgestellt, dass das erfindungsgemäße Flammschutzmittel (MKRS-HT und/oder MR2S-NT; resp. MS-Typen) eine abschwächende und/oder abschirmende Wirkung auf elektromagnetischer Strahlung, insbesondere auf Elektrosmog, aufweist.

Unter dem Begriff "Elektrosmog" wird u.a. im Folgenden eine überhöhte "Konzentration" elektromagnetischer Felder mit möglicherweise gesundheitsschädlichen Auswirkungen auf die belebte Natur, insbesondere Menschen, Tiere, Pflanzen, sonstige Lebewesen und einzelne Zellen verstanden, wie beispielsweise Mobilfunkstrahlung und/oder niederfrequente Magnetfelder, beispielsweise von Hochspannungsleitungen, usw.

In bestimmten vorteilhaften Ausführungsformen der erfindungsgemäßen Verwendung handelt es sich bei der elektromagnetischen Strahlung insbesondere um niederfrequente elektrische und/oder magnetische Felder.

In anderen bestimmten vorteilhaften Ausführungsformen der erfindungsgemäßen Verwendung handelt es sich bei der elektromagnetischen Strahlung insbesondere um Mobilfunkstrahlung.

In manchen vorteilhaften Ausführungsformen der Erfindung wird das erfindungsgemäße Flammschutzmittel für EMP (im Englischen: electro-magnetic protection)-Anwendungen eingesetzt.

In anderen vorteilhaften Ausführungsformen der Erfindung wird das erfindungsgemäße Flammschutzmittel (MKRS-HT und/oder MR2S-NT; zur Abschwächung bzw. Abschirmung von elektromagnetischer Strahlung in einem Frequenzbereich von zwischen 1 Hz und 10 GHz eingesetzt.

In bestimmten vorteilhaften Ausführungsformen der Erfindung wird das erfindungsgemäße Flammschutzmittel (MKRS-HT und/oder MR2S-NT; mit einem oder mehreren Polymeren vermischt. Dadurch lassen sie sich in jede beliebige Form bringen und/oder auch chemisch und/oder physikalisch verschäumen. Dadurch kann weiterhin die Herstellung von beliebig geformten abgeschirmten Räumen oder auch von Verpackungen von sensiblen elektronischen und/oder elektrischen Geräten vorteilhaft ermöglicht sein.

In weiteren vorteilhaften Ausführungsformen der Erfindung können ein oder mehrere Polymere, die wenigstens mit einem des erfindungsgemäßen Flammschutzmittels (MKRS-HT und/oder MR2S-NT in wechselnden Prozentgehalten vermischt sind, eine Leitfähigkeit aufweisen, die die Leitung eines elektrischen Stromes, insbesondere wie in einem Leiter, ermöglicht. Dadurch kann beispielsweise ein Faraday'scher Käfig gebildet werden.

In noch weiteren vorteilhaften Ausführungsformen der Erfindung können ein oder mehrere Polymere, die wenigstens mit einem des erfindungsgemäßen Flammschutzmittels (MKRS-HT und/oder MR2S-NT;) in wechselnden Prozentgehalten vermischt sind, als Folie ausgebildet sein. Dadurch kann beispielsweise ein abzuschirmender Raum ausgekleidet oder umhüllt und so ein Faraday'scher Käfig gebildet werden. Dieser leichte und preiswert entstandene Faraday'sche Käfig schützt dabei vorteilhaft das Rauminnere vor elektromagnetischen Pulsen und verhindert so ein Einkoppeln in das Rauminnere und eventuell dort befindliche Elektrik und/oder Elektronik. Dadurch können auch vorteilhaft sich im Raum befindliche Personen vor dem sog. Elektro-Smog geschützt werden. Der Faraday'sche Käfig kann auch vorteilhaft "unter Putz" in Form der zitierten Folie unsichtbar installiert werden.

In anderen bestimmten vorteilhaften Ausführungsformen der Erfindung kann es auch vorgesehen sein, beispielsweise ein Elastomer-modifiziertes Polyurethan als Polymer zu verwenden, um einen leitfähigen (insbesondere Industrie-) Bodenbelag herzustellen. Ein solcher Belag kann vorteilhaft eine Aufladung des menschlichen Körpers ableiten und diese so für elektronische Bauteile unschädlich machen. Ein solcher Belag kann auch vorteilhaft in vielen Bereichen eingesetzt werden, wo leitfähige Böden, insbesondere in der Industrie, vorgeschrieben sind, um die Gefahr von (u.a. Staub-) Explosionen, bedingt durch statische Aufladung, zu vermeiden.

In noch anderen vorteilhaften Ausführungsformen der Erfindung wird das erfindungsgemäße Flammschutzmittel in einem Bauteil, insbesondere in einem elektrischen und/oder in einem elektronischen Bauteil und/oder in einem Schaltkreis verwendet.

In weiteren vorteilhaften Ausführungsformen der Erfindung wird das erfindungsgemäße Flammschutzmittel zur Herstellung eines Bauteils, insbesondere eines Bauteils, das zur Verminderung bzw. Abschirmung von elektromagnetischer Strahlung geeignet und/oder vorgesehen ist, verwendet.

In noch weiteren vorteilhaften Ausführungsformen der Erfindung wird das erfindungsgemäße Flammschutzmittel zusammen mit einem thermoplastischen, duromeren und/oder elastomeren Material eingesetzt. Dabei kann vorteilhaft vorgesehen sein, dass der Anteil des Flammschutzmittels insbesondere 50 bis 98 Gew.-%, bezogen auf das Bauteil, beträgt.

Die weiter oben diskutierten flammhemmenden bzw. flammschützenden Eigenschaften des erfindungsgemäßen Flammschutzmittels können vorteilhaft mit den wärmespeichernden, wärmedämmenden, wärmeisolierenden und/oder schalldämmenden und/oder Schall schützenden und/oder Strahlung abschwächenden und/oder Strahlung abschirmenden Eigenschaften des erfindungsgemäßen Flammschutzmittels gezielt und in kontrollierter Weise kombiniert werden, um positive Mehreffekte zu erzielen.

**Patentansprüche**

1. Anorganisches, halogenfreies Flammschutzmittel aus modifiziertem, karbonisierten Rotschlamm, insbesondere für den Hochtemperaturbereich, (MKRS-HT) mit einer mineralischen Zusammensetzung von

    - 10 bis 50 Gewichtsprozent Eisenverbindungen,

- 12 bis 35 Gewichtsprozent Aluminiumverbindungen,
- 5 bis 17 Gewichtsprozent Siliziumverbindungen,
- 2 bis 10 Gewichtsprozent Titandioxid,
- 0,5 bis 6 Gewichtsprozent Calciumverbindungen und
- gegebenenfalls unvermeidbare Verunreinigungen,

**dadurch gekennzeichnet dass**,
das Gewichtsverhältnis von Fe(II)carbonat zu den Oxiden des Eisens mindestens 1 ist.

2. Anorganisches, halogenfreies Flammschutzmittel nach Anspruch 1, wobei der modifizierte, karbonisierte Rotschlamm ein modifizierter, karbonisierter und rehydratisierter Rotschlamm ist,
**dadurch gekennzeichnet dass**,
das Gewichtsverhältnis der Summe von Eisenhydroxid und Eisenoxidhydrat zu den Oxiden des Eisens mindestens 1 beträgt.

3. Flammschutzmittel nach Anspruch 1 oder Anspruch 2, wobei der Anteil an wasserlöslichem Natriumverbindungen, ausgedrückt als Gewichtsprozent $Na_2O$, nicht mehr als 0,03 beträgt und/oder
wobei die mittlere Teilchengröße (d50) nicht mehr als 50 $\mu$m, vorzugsweise 0,5 bis 10 $\mu$m bzw. 100 bis 900 nm beträgt, und/oder
wobei die Restfeuchte nicht mehr als 0,4 Gewichtsprozent beträgt.

4. Flammschutzmittel nach einem der Ansprüche 1 bis 3, wobei die Oberfläche des modifizierten Rotschlamms mit mindestens einer Substanz versehen ist, welche die Verträglichkeit der Teilchen des modifizierten Rotschlamms mit einer Polymermatrix verbessert, wobei die Substanz insbesondere ein Oberflächenmodifizierungsmittel ist, ausgewählt aus der Gruppe, bestehend aus Organosilanen, Organotitanaten, Organo-Zirkonaluminaten, Carbonsäurederivaten, Weichmachern, Oligomer- und Polymer-Vorstufen, Ionomeren, Borsäure und deren Metallsalze und Derivate, Zinkstannaten, Zinkhydroxystannaten oder Kombinationen hiervon, und/oder
wobei das Flammschutzmittel in Kombination mit Synergisten, insbesondere Organoclays, Zinnverbindungen und Boraten, vorliegt.

5. Flammschutzmittel nach einem der Ansprüche 1 bis 4, wobei das Flammschutzmittel ferner mindestens einen weiteren flammhemmenden Zusatz in einem Anteil bis zu 70 Gewichtsprozent enthält, wobei insbesondere mindestens einer der weiteren flammhemmenden Zusätze eine endotherm reagierende Substanz ist, insbesondere eine endotherm reagierende Substanz, ausgewählt aus der Gruppe, bestehend aus Aluminiumhydroxid, Boehmit, Gibbsit, Goethit, Magnesiumhydroxid, Huntit, Brucit oder Mischungen hiervon.

6. Verfahren zur Herstellung eines anorganischen, halogenfreien Flammschutzmittels gemäß Anspruch 1 oder 2, umfassend die Schritte:

   a) Bereitstellen von Rotschlamm,
   b) Reduzieren der in dem Rotschlamm enthaltenen Eisen(III)-Verbindungen in saurer Lösung zu Eisen(II)-Verbindungen,
   c) Zugeben einer Carbonatverbindung zu der in Schritt b) erhaltenen Eisen(II)-Verbindungen enthaltenden Lösung, wobei Eisen(II)carbonat (Siderit) gebildet wird.

7. Verfahren zur Herstellung eines anorganischen, halogenfreien Flammschutzmittels gemäß Anspruch 1 oder 2, umfassend die Schritte:

   a) Bereitstellen von Rotschlamm;
   b) Separate Herstellung von Eisen(II)carbonat aus zur Verfügung stehenden Ausgangssubstanzen;
   c) Vermischen von Rotschlamm und Eisen(II)carbonat;
   d) Erhalten von modifiziertem carbonisiertem Rotschlamm (MKRS-hat).

8. Brandgeschütztes Stoffsystem, umfassend ein brennbares Material und ein Flammschutzmittel gemäß einem der Ansprüche 1 bis 5, wobei das brennbare Material insbesondere ein Baustoff, ein Gummiprodukt, eine Spanplatte, eine Fassadenverkleidung oder ein Kunststoffprodukt, insbesondere eine Kabelummantelung, Kabelisolationsmasse oder ein Kabelfüll-Compound, ist und/oder
wobei das Stoffsystem insbesondere das Flammschutzmittel in einem Anteil von 3 bis 95 Gewichtsprozent enthält.

9. Verwendung des Flammschutzmittels gemäß einem der Ansprüche 1 bis 5 als Flammhemmer für brennbare Materialien, insbesondere brennbare Baustoffe, Gummi, Spanplattenmaterial, Kunststoffe, insbesondere Kabelummantelungen, Kabelisolationsmasse oder Kabelfüll-Compounds.

10. Verfahren zur Herstellung eines brandgeschützten Stoffsystems, umfassend die Schritte:

a) Bereitstellen eines brennbaren Materials,
b) Beschichten oder Vermengen des brennbaren Materials mit dem Flammschutzmittel gemäß einem der Ansprüche 1 bis 5, und dadurch
c) Erhalten des brandgeschützten Stoffsystems.

11. Verfahren nach Anspruch 10, wobei das Flammschutzmittel vor dem Beschichten oder Vermengen des Schrittes b) physikalisch behandelt, insbesondere gemahlen oder desagglomeriert wird, vorzugsweise zusammen mit Synergisten, insbesondere Organoclays (Nanoclays), Zinnverbindungen und Boraten, und/oder mindestens einem weiteren flammhemmenden Zusatz, wobei die Synergisten bei Verwendung mit dem erfindungsgemäßen Flammschutzmittel in Elastomer-Thermoplast- und Duromer-Systemen insbesondere in Form sog. "Master Batches" in flüssiger, pastöser oder Granulat-Form bei der Verarbeitung zugegeben werden und/oder
wobei das in Schritt b) genannte Flammschutzmittel einer Oberflächenmodifizierung unterzogen wird, wobei die Oberflächenmodifizierung des Flammschutzmittels insbesondere ein Versehen der Oberfläche des Flammschutzmittels mit einem Oberflächenmodifizierungsmittel umfasst, das aus der Gruppe, bestehend aus Organosilanen, Organotitanaten, Organo-Zirkonaluminaten, Carbonsäurederivaten, Weichmachern, Oligomer- und Polymer-Vorstufen, Ionomeren, Borsäure und deren Metallsalze und Derivate, Zinkstannaten, Zinkhydroxystannaten oder Kombinationen hiervon, ausgewählt ist.

12. Verwendung des Flammschutzmittels gemäß einem der Ansprüche 1 bis 5

- als zumindest teilweises, insbesondere vollständiges, Substitut bzw. Ersatzmittel für Antimontrioxid ($Sb_2O_3$) in Polyvinylchlorid (PVC)-haltigen Zusammensetzungen bzw. PVC-haltigen Compounds und/oder halogenhaltigen flammgeschützten Zusammensetzungen und/oder
- als Synergist in Polyvinylchlorid (PVC)-haltigen Zusammensetzungen bzw. PVC-haltigen Compounds und/oder halogenhaltigen flammgeschützten Zusammensetzungen, wobei der Synergist insbesondere in der Lage ist, bei einem Brand entstehende halogenhaltige Zwischenprodukte abzufangen bzw. zu binden und/oder
- zur Erhöhung der Thermostabilität von Polyvinylchlorid (PVC)-haltigen Zusammensetzungen bzw. PVC-haltigen Compounds und/oder halogenhaltigen flammgeschützten Zusammensetzungen,

wobei es sich bei den PVC-haltigen Zusammensetzungen insbesondere um PVC-haltige Kabel bzw. PVC-haltige Kabelcompounds handelt, die optional ferner einen Weichmacher enthalten.

13. Verwendung des Flammschutzmittels gemäß einem der Ansprüche 1 bis 5

- zur Wärmespeicherung bzw. als wärmespeicherndes Material und/oder
- zur Wärmedämmung bzw. Wärmeisolation bzw. als wärmedämmendes bzw. wärmeisolierendes Material und/oder
- zur Schalldämmung bzw. als Schallschutz bzw. als schalldämmendes Material.

14. Verwendung nach Anspruch 13, wobei das Flammschutzmittel in einem Baumaterial und/oder Anlagenbaumaterialien vorliegt und/oder
wobei das Flammschutzmittel in einer Matrix, insbesondere einer thermoplastischen oder duromeren Matrix, insbesondere einer Polymermatrix, vorliegt und/oder wobei das Flammschutzmittel in einem Composit, enthaltend eine Matrix und optional Hilfsstoffe und Additive, vorliegt, wobei das Composit massiv und/oder geschäumt ist, insbesondere einen geschäumten Kern und eine geschlossene Oberfläche aufweist, und wobei das Composit insbesondere ein spezifisches Gewicht von 15 bis 800 kg/m$^3$ aufweist und/oder wobei das Flammschutzmittel in einem Schaum vorliegt, der ein thermoplastisches bzw. ein mit einem thermoplastischen Elastomer (TPE) modifiziertes vernetztes Material aufweist, insbesondere ein Material, ausgewählt aus der Gruppe, bestehend aus Polyethylen (PE), Polypropylen (PP), Polystyrol, wie extrudierter Polystyrolhartschaum (X-PS), thermoplastischem Elastomer (TPE) und Mischungen davon und/oder wobei das Flammschutzmittel in einem ein Polyurethan enthaltender oder daraus bestehender Schaum vorliegt, der geschlossenzellig und/oder offenzellig ist und insbesondere ein spezifisches Gewicht von 15 bis 800 kg/m$^3$ aufweist.

**15.** Verwendung des Flammschutzmittels gemäß einem der Ansprüche 1 bis 5 zur Abschwächung bzw. Abschirmung von elektromagnetischer Strahlung, insbesondere in einem Bauteil, insbesondere einem elektrischen und/oder elektronischen Bauteil, bzw. einem Schaltkreis.

**16.** Verwendung des Flammschutzmittels gemäß einem der Ansprüche 1 bis 5 zur Herstellung eines Bauteils, das zur Verminderung bzw. Abschirmung von elektromagnetischer Strahlung geeignet ist, wobei das Flammschutzmittel insbesondere zusammen mit einem thermoplastischen, duromeren und/oder elastomeren Material eingesetzt wird, wobei der Anteil des Flammschutzmittels insbesondere 50 bis 98 Gew.-%, bezogen auf das Bauteil, beträgt.

**Claims**

**1.** Inorganic, halogen-free flame retardant produced from modified, carbonised red mud, in particular for the high-temperature range, (MKRS-HT) with a mineral composition of

  - 10 to 50 % by weight of iron compounds,
  - 12 to 35 % by weight of aluminium compounds,
  - 5 to 17 % by weight of silicon compounds,
  - 2 to 10 % by weight of titanium dioxide,
  - 0.5 to 6 % by weight of calcium compounds, and
  - possibly unavoidable impurities, **characterised in that** the weight ratio of Fe(II) carbonate to the oxides of iron is at least 1.

**2.** Inorganic, halogen-free flame retardant according to claim 1, wherein the modified, carbonised red mud is a modified, carbonised and rehydrated red mud, **characterised in that** the weight ratio of the sum of iron hydroxide and iron oxide hydrate to the oxides of iron is at least 1.

**3.** Flame retardant according to claim 1 or claim 2, wherein the proportion of watersoluble sodium compounds, expressed in percentage by weight of $Na_2O$ is no more than 0.03 % by weight and/or wherein the average particle size (d50) is no more than 50 $\mu$m, is preferably 0.5 to 10 $\mu$m, or 100 to 900 nm, and/or wherein the residual moisture content is no more than 0.4 % by weight.

**4.** Flame retardant according to one of claims 1 to 3, wherein the surface of the modified red mud is provided with at least one substance which improves the compatibility of the particles of the modified red mud with a polymer matrix, wherein the substance is a surface modifying agent, selected from the group consisting of organosilanes, organotitanates, organo-zirconium aluminates, carboxylic acid derivatives, softeners, oligomer and polymer precursors, ionomers, boric acid and the metal salts and derivatives thereof, zinc stannates, zinc hydroxystannates or combinations thereof, and/or wherein the flameproofing agent is present in combination with synergists, in particular organoclays, tin compounds and borates.

**5.** Flame retardant according to one of claims 1 to 4, wherein the flameproofing agent also contains at least one further flame retardant additive in a proportion of up to 70 % by weight, wherein in particular at least one of the further flame-retardant additives is an endothermally reacting substance, in particular an endothermally reacting substance selected from the group consisting of aluminium hydroxide, boehmite, gibbsite, goethite, magnesium hydroxide, huntite, brucite or mixtures thereof.

**6.** Method for producing an inorganic, halogen-free flame retardant according to claim 1 or 2, comprising the steps of:

  a) providing red mud,
  b) reducing the iron(III) compounds contained in the red mud in acidic solution to iron(II) compounds,
  c) adding a carbonate compound to the solution containing iron(II) compounds obtained in step b), wherein iron(II) carbonate (siderite) is formed.

**7.** Method for producing an inorganic, halogen-free flame retardant according to claim 1 or 2, comprising the steps of:

  a) providing red mud,
  b) separately producing iron(II) carbonate from available starting substances;
  c) mixing red mud and iron(II) carbonate;

d) obtaining modified carbonised red mud (MKRS-hat).

8. Fireproofed material system, comprising a combustible material and a flame retardant according to one of claims 1 to 5, wherein the combustible material is in particular a building material, a rubber product, a chipboard, a facade cladding or a plastic product, in particular a cable sheathing, cable insulation compound or a cable filling compound, and/or wherein the material system in particular contains the flame retardant in a proportion of 3 to 95 % by weight.

9. Use of the flame retardant according to one of claims 1 to 5 as flame retardant for combustible materials, in particular combustible building materials, rubber, chipboard material, plastics, in particular cable sheathings, cable insulation compound or cable filling compounds.

10. Method for producing a fireproofed material system, comprising the steps of:

a) providing a combustible material,
b) coating or blending the combustible material with the flame retardant according to one of claims 1 to 5, and thereby
c) obtaining the fireproofed material system.

11. Method according to claim 10, wherein before the coating or blending in step b) the flame retardant is physically treated, in particular ground or disagglomerated, preferably together with synergists, in particular organoclays (nanoclays), tin compounds and borates, and/or at least one further flame-retardant additive, wherein when used with the flame retardant according to the invention in elastomeric, thermoplastic and thermosetting systems in the form of so-called "master batches" the synergists are added in liquid, paste or granule form during the processing, and/or wherein the flame retardant referred to in step b) is subjected to a surface modification, wherein the surface modification of the flame retardant in particular comprises providing the surface of the flameproofing agent with a surface modifying agent which is selected from the group consisting of organosilanes, organotitanates, organo-zirconium aluminates, carboxylic acid derivatives, softeners, oligomer and polymer precursors, ionomers, boric acid and the metal salts and derivatives thereof, zinc stannates, zinc hydroxystannates or combinations thereof.

12. Use of the flame retardant according to one of claims 1 to 5

- as at least partial, in particular complete, substitute or surrogate for antimony trioxide ($Sb_2O_3$) in compositions containing polyvinyl chloride (PVC) or compounds containing PVC and/or halogen-containing flameproof compositions, and/or
- as synergist in compositions containing polyvinyl chloride (PVC) or compounds containing PVC and/or halogen-containing flameproof compositions, wherein the synergist is in particular capable of trapping or binding halogen-containing intermediate products produced in the event of a fire, and/or
- in order to increase the thermal stability of compositions containing polyvinyl chloride (PVC) or compounds containing PVC and/or halogen-containing flameproof compositions,

wherein the PVC-containing compositions are in particular PVC-containing cables or PVC-containing cable compounds which optionally also contain a softener.

13. Use of the flame retardant according to one of claims 1 to 5

- for heat storage or as a heat-storage material and/or
- for thermal insulation or as a thermal insulating material, and/or
- for sound insulation or as sound proofing or as a sound-insulating material.

14. Use according to claim 13, wherein the flame retardant is present in a building material and/or equipment construction materials and/or wherein the flame retardant is present in a matrix, in particular a thermoplastic or thermosetting matrix, in particular a polymer matrix, and/or wherein the flame retardant is present in a composite, containing a matrix and optionally adjuvants and additives, wherein the composite is solid and/or foamed, and in particular has a foamed core and a closed surface, and wherein the composite has in particular a specific weight of 15 to 800 kg/m$^3$, and/or wherein the flame retardant is present in a foam which has a thermoplastic material or a modified cross-linked material with a thermoplastic elastomer (TPE), in particular a material selected from the group consisting of polyethylene (PE), polypropylene (PP), polystyrene, in particular such as extruded polystyrene hard foam (X-PS), thermoplastic elastomer (TPE) and mixtures thereof, wherein the flame retardant is present in a foam which contains a polyurethane or consists thereof, which is closed-celled and/or open-celled and in particular has a specific weight of 15 to 800 kg/m$^3$.

15. Use of the flame retardant according to one of claims 1 to 5 for attenuating or shielding electromagnetic radiation, in particular in a component, in particular an electric and/or electronic component, or a circuit.

16. Use of the flame retardant according to one of claims 1 to 5 for producing a component which is suitable for reducing or shielding electromagnetic radiation, wherein the flame retardant is used in particular together with a thermoplastic, thermosetting and/or elastomeric material, wherein the proportion of the flame retardant is in particular 50 to 98 % by weight, based on the component.


**Revendications**

1. Agent ignifuge inorganique non halogéné à base de boue rouge modifiée carbonisée, en particulier pour les plages de températures élevées (MKRS-HT), présentant une composition minérale de

   - 10 à 50 pourcent du poids de composés ferreux,
   - 12 à 35 pourcent du poids de composés d'aluminium,
   - 5 à 17 pourcent du poids de composés de silicium,
   - 2 à 10 pourcent du poids de dioxyde de titane,
   - 0,5 à 6 pourcent du poids de composés de calcium
   - et éventuellement des impuretés inévitables,

   **caractérisé en ce que**
   le rapport pondéral entre le carbonate de Fe(II) et les oxydes de fer est égal à au moins 1.

2. Agent ignifuge inorganique non halogéné conformément à la Revendication 1 étant précisé que la boue rouge carbonisée est une boue rouge modifiée, carbonisée et réhydratée,
   **caractérisée en ce que**
   le rapport pondéral entre la somme de l'hydroxyde de fer et de l'hydrate d'oxyde de fer et les oxydes de fer est égal à au moins 1.

3. Agent ignifuge inorganique non halogéné conformément à la Revendication 1 ou à la Revendication 2 étant précisé que la teneur en composés de sodium, exprimé en pourcentage du poids de Na$_2$O, n'est pas supérieur à 0,03 et/ou étant précisé que les particules moyennes (d50) ne mesurent pas plus de 50 $\mu$m, idéalement entre 0,5 $\mu$m et 10 $\mu$m, ou 100 à 900 Nm, et/ou
   l'humidité résiduelle ne dépasse pas 0,4 pourcent du poids.

4. Agent ignifuge inorganique non halogéné conformément à l'une des Revendications 1 à 3 étant précisé que la surface de la boue rouge modifiée est dotée d'au moins une substance améliorant la compatibilité des particules de la boue rouge modifiée avec une matrice en polymère,
   étant précisé que la substance est, en particulier, une substance de modification de la surface, sélectionnée parmi le groupe formé par les organosilanes, organotitanates, organo-aluminates de zirconium, dérivés d'acide carboxylique, adoucissants, pré-oligomères et pré-polymères, ionomères, acides boriques et leurs sels métalliques et dérivés, stannates de zinc, stannates d'hydroxydes de zinc ou combinaisons de ceux-ci, et/ou étant précisé que l'agent ignifuge est en combinaison avec des synergistes, en particulier des organoargiles, des composés d'étain et des borates.

5. Agent ignifuge inorganique non halogéné conformément à l'une des Revendications 1 à 4 étant précisé qu'il comporte, en outre, au moins un autre adjuvant ignifuge dans une proportion pouvant atteindre 70 pourcent du poids, étant précisé qu'au moins un des autres adjuvants ignifuges est une substance à réaction endothermique, en particulier une substance à réaction endothermique sélectionnée dans groupe formé par l'hydroxyde d'aluminium, la boehmite, la gibbsite, la goethite, l'hydroxyde de magnésium, la huntite, la brucite ou un mélange de ceux-ci.

6. Procédé de production d'un agent ignifuge inorganique non halogéné conformément à la Revendication 1 ou 2, comprenant les étapes suivantes :

a) préparation de la boue rouge,
b) réduction des composés de fer (III) contenus dans la boue rouge en solution acide en composés de fer (II),
c) ajout d'un composé de carbonate aux composés de fer (II) obtenus à l'étape b), étant précisé que du carbonate de fer (II) (sidérite) est obtenu.

7. Procédé de production d'un agent ignifuge inorganique non halogéné conformément à la Revendication 1 ou 2, comprenant les étapes suivantes :

a) préparation de la boue rouge,
b) production séparée de carbonate de fer (II) à partir des substances de départ disponibles,
c) mélange de la boue rouge et du carbonate de fer (II),
d) obtention d'une boue rouge carbonisée modifiée (MKRS-hat).

8. Système de matière ignifuge comprenant un matériau combustible et un agent ignifuge conformément à l'une quelconque des Revendications 1 à 5, étant précisé que le matériau combustible est en particulier un matériau de construction, un produit en caoutchouc, un panneau de particules, un revêtement de façade ou un produit en matériau plastique, en particulier une gaine de câble, une masse d'isolation de câble ou un composé de remplissage de câble, et / ou
étant précisé que le système de matière comporte notamment l'agent ignifuge selon une proportion de 3 à 95 pourcent du poids.

9. Utilisation de l'agent ignifuge conformément à l'une quelconque des Revendications 1 à 5 comme retardateur de flamme pour des matières inflammables en particulier pour des matériaux de construction, du caoutchouc, du matériau de panneau de particules, des matériaux en plastique, en particulier des gaines de câble, des masses d'isolation de câble ou des composés de remplissage de câble.

10. Procédé de fabrication d'un système de matière ignifuge comprenant les étapes suivantes :

a) préparation d'un matériau combustible,
b) recouvrement ou mélange du matériau combustible avec l'agent ignifuge conformément à l'une quelconque des Revendications 1 à 5, et de ce fait
c) obtention du système de matière ignifuge.

11. Procédé conformément à la Revendication 10 étant précisé qu'avant le recouvrement ou le mélange de l'étape b), l'agent ignifuge bénéficie d'un traitement physique, en particulier, il est moulu ou désaggloméré, de préférence avec des synergistes, en particulier des organoargiles (nano-argiles), des composés de zinc et des borates, et / ou au moins un autre adjuvant ignifuge, étant précisé que les synergistes, lorsqu'ils utilisés avec l'agent ignifuge objet de la présente invention dans des systèmes élastomères, thermoplastes et duromères, sont ajoutés en particulier sous forme de ce que l'on appelle les « master batches », sous forme liquide, pâteuse ou granuleuse lors de la transformation et / ou
étant précisé que l'agent ignifuge cité à la section b) est soumis à une modification de la surface, étant précisé que la modification de la surface de l'agent ignifuge est en particulier l'application sur la surface de l'agent ignifuge d'un agent de modification de la surface parmi le groupe formé par les organosilanes, organotitanates, organo-aluminates de zirconium, dérivés d'acide carboxylique, adoucissants, pré-oligomères et pré-polymères, ionomères, acides boriques et leurs sels métalliques et dérivés, stannates de zinc, stannates d'hydroxydes de zinc ou combinaisons de ceux-ci.

12. Utilisation de l'agent ignifuge conformément à l'une quelconque des Revendications 1 à 5

- du moins partiellement, en particulier entièrement, en tant que substitut ou produit de substitution au trioxyde d'antimoine ($Sb_2O_3$) dans des compositions contenant du chlorure de polyvinyle (PVC) ou des composés contenant du PVC et / ou des compositions ignifugées halogénées
et / ou
- en tant que synergiste dans des compositions contenant du chlorure de polyvinyle (PVC) ou des composés contenant du PVC et / ou des compositions ignifugées halogénées, étant précisé que le synergiste est en particulier capable de capturer ou lier des produits intermédiaires halogénés produits lors d'un incendie et / ou
- pour l'augmentation de la thermostabilité de compositions contenant du chlorure de polyvinyle (PVC) ou des composés contenant du PVC et / ou des compositions ignifugées halogénées, étant précisé que les compositions contenant du chlorure de polyvinyle (PVC) sont en particulier des câbles contenant du PVC ou des composés de câbles contenant du PVC, qui contiennent en outre, en option, un adoucissant.

13. Utilisation de l'agent ignifuge conformément à l'une quelconque des Revendications 1 à 5

   - pour le stockage de chaleur ou en tant que matériau accumulateur de chaleur et / ou
   - pour l'isolation thermique ou comme matériau isolant et / ou
   - pour l'isolation phonique ou protection phonique ou comme matériau d'insonorisation.

14. Utilisation de l'agent ignifuge conformément à la Revendication 13 étant précisé que l'agent ignifuge est contenu dans un matériau de construction et / ou un matériau de construction d'équipement et / ou étant précisé que l'agent ignifuge est contenu dans une matrice, en particulier une matrice thermoplastique ou duromère, en particulier une matrice polymère et /ou étant précisé que l'agent ignifuge est contenu dans un composite comprenant une matrice et, en option, des agents auxiliaires et des additifs, étant précisé que le composite est massif et / ou expansé, et présente en particulier un coeur expansé et une surface fermée, et étant précisé que le composite présente en particulier un poids spécifique de 15 à 800 kg/m$^3$ et / ou étant précisé que l'agent ignifuge est contenu dans une mousse qui présente un matériau réticulé thermoplastique ou un matériau modifié par un élastomère thermoplastique (TPE), en particulier un matériau sélectionné dans le groupe comprenant le polyéthylène (PE), le polypropylène (PP), le polystyrène, comme la mousse polystyrène extrudée (X-PS), l'élastomère thermoplastique (TPE) et les mélanges de ceux-ci et / ou étant précisé que l'agent ignifuge est contenu dans une mousse comprenant un polyuréthane ou se composant de polyuréthane qui présente des alvéoles fermées et / ou ouvertes, et présente en particulier un poids spécifique de 15 à 800 kg/m$^3$.

15. Utilisation de l'agent ignifuge conformément à l'une quelconque des Revendications 1 à 5 pour l'atténuation d'un rayonnement électromagnétique ou le blindage contre le rayonnement électromagnétique, en particulier dans un élément de construction, en particulier dans un élément de construction électrique et / ou électronique, ou un circuit.

16. Utilisation de l'agent ignifuge conformément à l'une quelconque des Revendications 1 à 5 pour la fabrication d'un élément de construction adapté pour l'atténuation d'un rayonnement électromagnétique ou le blindage contre le rayonnement électromagnétique, étant précisé que l'agent ignifuge est utilisé en particulier en combinaison avec matériau thermoplastique, duromère et / ou élastomère, étant précisé que la proportion de l'agent ignifuge par rapport à l'élément de construction est de 50 à 98 % en poids.

## Rotschlamm 100%

Fig. 1

## Rotschlamm auf maximalen Gibbsit-Gehalt optimiert

Fig. 2

# Rotschlamm auf Goethit –Gehalt hin angereichert

Fig. 3

# Rotschlamm mit mittlerem Siderit-Gehalt

Fig. 4

43

Rotschlamm auf Siderit- und Goethit-Gehalt optimiert

Fig. 5

Fig. 6

Al(OH)3+Rotschlamm

A

B

Intensität

Beugungswinkel 2 Theta

Fig. 7

Fig. 8

Siderit+Rotschlam

Intensität

Beugungswinkel 2 Theta

A

B

EP 2 948 503 B1

Fig. 9

Rotschlamm + Siderit + Goethit

FIG. 10

FIG. 11

FIG. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012126487 A1

- CN 101624457 A

**In der Beschreibung aufgeführte Nicht-Patentliteratur**

- **SUNIL K. SHARMA ; A.A. ANSARI BESCH-REIBEN.** *Fire Technology,* 2002, vol. 38, 57-70